# EUROPEAN PATENT SPECIFICATION

(11) **EP 3 255 742 B1**
(45) Date of publication and mention of the grant of the patent: **14.08.2019**
(21) Application number: 17179558.6
(22) Date of filing: 20.12.2012
(51) Int. Cl.: H01S 5/022, H01S 5/42

(54) **SURFACE MOUNT PACKAGING FOR HIGH-SPEED VERTICAL CAVITY SURFACE EMITTING LASERS**
OBERFLÄCHENMONTAGEVERPACKUNG FÜR HOCHGESCHWINDIGKEITS-SENKRECHT-OBERFLÄCHENEMISSIONSLASER
EMBALLAGE À MONTAGE EN SURFACE POUR LASERS À ÉMISSION EN SURFACE DE CAVITÉ VERTICALE À GRANDE VITESSE

(30) Priority: 24.12.2011 US 201113337098; 05.07.2012 US 201213541906
(43) Date of publication of application: 13.12.2017
(62) Divisional of application: 12198546.9
(73) Proprietor: Princeton Optronics, Inc., Mercerville, NJ 08619 (US)
(72) Inventor: SEURIN, Jean F., Princeton Junction, NJ 08550 (US); GHOSH, Chuni, Princeton Junction, NJ 08550 (US); WANG, Qing, Plainsboro, NJ 08536 (US); WATKINS, Laurence, Pennington, NJ 08534 (US)
(74) Representative: Dehns

(56) References cited:
- EP-A2- 0 975 072
- EP-A2- 1 653 523
- EP-A2- 2 128 939
- US-A1- 2007 085 101

## Description

This invention relates to the field of packaging for high-speed laser Vertical Cavity Surface Emitting Laser (VCSEL) and arrays of VCSELs illumination systems for various applications, such as a 3D imaging and gesture recognition illuminating system. Laser illumination sources have diverse applications depending upon different operating modes such as, continuous wave (CW), Quasi Continuous Wave (QCW) or pulsed operation. To name just a few, laser illumination is widely used in the field of surveillance imaging, recording images of objects moving at high speed, gesture recognition, time of flight illumination for three dimensional (3D) imaging, etc. Currently, laser devices operating in the visible as well as in the Infra-red (IR) region of the electromagnetic spectrum are readily available. However, current cost of devices is rather high for other emerging applications particularly in consumer electronics and optics and/or in portable devices. Few key developments that would make laser illumination sources more attractive and affordable for emerging applications are, availability of a speckle free illumination over large area, short and/ or fast pulse illumination system, high-speed and/or low impedance peripheral devices and connectors such as, driving electronics, high-speed connectors, optical elements for beam shaping, and small foot print.

Specific applications of short optical pulses include but are not limited to a sequence of short illumination pulses for many other sensing applications such as tracking movement and 3D measurement using technologies such as structured light. Another example is the coding of illumination pulses to provide methods for discriminating between a coded illumination sequence and illumination effects from other nearby sources. Short optical pulses are also required for time-of-flight measurement between a source and an object for determining the depth or distance of the object.

For these types of applications, one basic requirement is a source of radiation at a specific wavelength (visible, IR, far IR etc.) which can be rapidly turned on and off to generate a short pulse or short pulse sequence of radiation. For illuminating a large scene for example, in a surveillance application, a high-energy pulse of radiation is required to be distributed uniformly over a large illuminating area. Short optical pulses having high-pulse energy can be generated in Q-switched or mode-locked solid state lasers that are optically pumped. However Q-switched or mode-locked lasers have large footprint, require high electrical energy requirement for operation and elaborate cooling peripheral equipment.

Alternatively, semiconductor diode laser sources such as, edge emitting laser (EEL) and vertical cavity surface emitting laser (VCSEL) can be fabricated to work at various wavelengths and can generate high energy short output pulses in a very small footprint. Diode lasers can be operated at drive current that are relatively small as compared to pump current required to operate a Q-switched or a mode locked solid state laser. While EELs are currently used for many applications including short pulse generation for optical communication, VCSELs have several distinct advantages over the EELs that make them more suitable for optical illumination applications.

One advantage of VCSELs is that the divergence angle of emitted light is very small. Consequently, emission from VCSELs is highly directional even at large distances from the origin. VCSEL emission in visible and infrared wavelengths may be obtained in a very narrow wavelength band allowing optically efficient filtering of background noise. VCSELs are also amenable to generating short pulses, thereby making these sources suitable for LIDAR type applications and for time domain distance discrimination applications such as seeing through fog and motion and gesture detection, etc.

In general, VCSELs have faster rise and fall times and therefore are capable of producing very short pulses. One advantage of short pulses from VCSELs is that the wavelength chirp is small which helps in wavelength filtering and high-speed detection. VCSELs also have a symmetric output radiation pattern which makes it much more adaptable to simple optical methods for generating or modifying, the output light for a desirable illumination pattern. For example, different beam shapes including but not limited to, a Gaussian, flat top or ring shape pattern may be generated by suitably designing a VCSEL's aperture or by using external beam shaping devices such as lenses, diffusers, etc. that can be used for a single VCSEL or arranged in an array to be used with a VCSEL array.

Another advantage of VCSELs is that many of them may be arranged in closely packed one or two dimensional arrays. VCSEL arrays, especially arrays of single mode VCSELs, are typically very high-speed devices and can be operated with pulse duration of the order of nanoseconds or less, and rise times of sub-nanoseconds. When operated together, an array of VCSELs produce high-energy pulses. Very compact high-power VCSEL arrays facilitate minimizing electrical conductor lengths and reducing inductance. As a result it is more suitable for applying fast rise time high drive current pulses thereby facilitating generation of high-energy short optical pulses from a VCSEL array. They can be operated at temperatures as high as about 100 deg C in enclosed environments. Simple optical methods such as providing apertures may be used to shape either individual beam or the collective emission from the entire array for producing a desirable illumination pattern. VCSEL arrays with their large number of emitters do not exhibit speckle effects which are typically seen in the output from EELs or other types of lasers. Eliminating speckle greatly increases the resolution of the illuminated image.

For high-speed operation of VCSEL, it is important that a fast electrical drive current can be applied. For applying a high-speed driving current it is essential that the parasitic elements are minimized while packaging VCSELs and VCSEL arrays. Furthermore, for high-power operation of VCSEL, high thermal conductivity of the package is also important. It can be well appreciated that for VCSEL arrays to be operated at high speed and at high power of the order of several Watts for example, packaging of the device must incorporate both the requirements simultaneously. Different arrangements for mounting VCSELs either for individual operation or collective operation for high output power, are described in number of patent and non-patent publications.

Current technology for packaging VCSELs is quite complex. In most instances, packages typically have electrical leads that are designed for through hole mounting on electronic circuit boards and are described in many prior art patent and non-patent literature publications.

EP2128939A2, US2007/085101A1 and EP1653523A2 disclose optical illuminator modules.

The present invention relates to an optical illuminator module as defined by claim 1. Optional or preferred features are defined by the dependent claims.

According to one aspect of the present invention, an optical illuminator module includes a Vertical Cavity Surface Emitting Laser (VCSEL) having a large area terminal and a second terminal. The optical illuminator module includes a submount including a first and second bonding pad that are electrically isolated from each other and positioned on a first surface. The large area terminal of the VCSEL is bonded to the first bonding pad such that the VCSEL is in thermal contact with the submount. The second terminal is electrically connected to the second bonding pad. The first and second bonding pads are electrically connected to a corresponding first and second bonding pad located on a second surface of the submount, which is opposite to the first surface of the submount. In various embodiments, the optical illuminator module can be configured to perform at least one of motion recognition, gesture recognition, and three-dimensional sensing.

In one embodiment, the first and second bonding pads on the first surface of the submount are wrapped around one or more edges of the submount, such that the first
and second bonding pads on the first surface of the submount are electrically connected to the corresponding first and second bonding pads positioned on the second surface of the submount. In another embodiment, the first and second bonding pads on the first surface of the submount are wrapped around one or more sides of the submount, such that the first and second bonding pads on the first surface of the submount are electrically connected to the corresponding first and second bonding pads positioned on the second surface of the submount. In yet another embodiment, the first and second bonding pads positioned on the first surface of the submount are electrically connected to the corresponding first and second bonding pads positioned on the second surface of the submount by first and second via holes. In this embodiment, the first and second bonding pads positioned on the first surface of the submount can be electrically connected to the corresponding first and second bonding pads positioned on the second surface of the submount by a plurality of first and a plurality of second via holes. In these various embodiments, the submount can be bonded to a heat sink such that the VCSEL is in thermal contact with the heat sink.

According to another aspect of the present invention, an optical illuminator module includes a plurality of VCSELs arranged to form a two-dimensional array of VCSELs having a light emitting surface on a first surface and a bonding surface on a second surface which is opposite to the first surface. One terminal of each of the plurality of VCSELs is electrically connected to a first terminal of the array of VCSELs and a second terminal of each plurality of VCSELs is electrically connected to a second terminal of the array of VCSELs. The optical illuminator module also includes a submount including a plurality of bonding pads that are electrically isolated from each other and positioned on a first surface. The plurality of bonding pads is electrically connected to a corresponding plurality of bonding pads located on a second surface of the submount such that the bonding surface of the array is in thermal contact with the submount. In various embodiments, the optical illuminator module can be configured to perform at least one of motion recognition, gesture recognition, and three-dimensional sensing.

In one embodiment, the plurality of bonding pads positioned on the first surface are wrapped around one or more edges of the submount, such that the plurality of bonding pads positioned on the first surface is electrically connected to the corresponding plurality of bonding pads positioned on the second surface of the submount. In another embodiment, the plurality of bonding pads positioned on the first surface are wrapped around one or more sides of the submount, such that the plurality of bonding pads positioned on the first surface is electrically connected to the corresponding plurality of bonding pads positioned on the second surface of the submount. In this embodiment, the plurality of bonding pads positioned on the first surface of the submount are electrically connected to the corresponding plurality of bonding pads positioned on the second surface of the submount by a plurality of via holes. In these various embodiments, the submount can be bonded to a heat sink such that the VCSEL is in thermal contact with the heat sink.

According to another aspect of the present invention, an optical illuminator system includes a printed circuit board comprising a plurality of transmission lines positioned on a surface of the printed circuit board. The optical illuminator system also includes plurality of VCSELs arranged to form an array of VCSELs having a light emitting surface on a first surface and a bonding surface on a second surface, wherein a first terminal of each of the plurality of VCSELs is electrically connected to a first terminal of the array and a second terminal of each plurality of VCSELs is electrically connected to a second terminal of the array. The optical illuminator system also includes a submount electrically bonded to a bonding pad of the printed circuit board. The submount includes a plurality of bonding pads that are electrically isolated from each other and positioned on a first surface. The first and the second terminal of the array are electrically connected to respective first and second bonding pads on the submount, such that the array is in thermal contact with the submount, and the plurality of bonding pads positioned on the first surface are electrically connected to a corresponding plurality of bonding pads located on a second surface of the submount, which is opposite to the first surface of the submount. In addition, the optical illuminator system includes an electronic module having at least one current driver circuit electrically bonded to the printed circuit board so that the VCSEL array is electrically connected to the at least one current driver circuit. In various embodiments, the optical illuminator module can be configured to perform at least one of motion recognition, gesture recognition, and three-dimensional sensing.

In one embodiment, the plurality of bonding pads positioned on the first surface are wrapped around one or more edges of the submount, such that the plurality of bonding pads positioned on the first surface is electrically connected to the corresponding plurality of bonding pads positioned on the second surface of the submount. In another embodiment, the plurality of bonding pads positioned on the first surface are wrapped around one or more sides of the submount, such that the plurality of bonding pads positioned on the first surface is electrically connected to the corresponding plurality of bonding pads positioned on the second surface of the submount. In this embodiment, the plurality of bonding pads positioned on the first surface of the submount are electrically connected to the corresponding plurality of bonding pads positioned on the second surface of the submount by a plurality of via holes. In these various embodiments, the submount can be bonded to a heat sink such that the VCSEL is in thermal contact with the heat sink.

In addition, the optical illuminator system can include numerous other features. For example, the optical illuminator system can include an enclosure having a base on a first surface where the printed circuit is bonded to the base and the base is in thermal contact with a heat sink. The optical illuminator system can also include a transparent region positioned on the first surface of the array of VCSELs that passes light emitting from the surface of the array of VCSELs.

According to another aspect of the present invention, an illuminator module includes a plurality of VCSELs comprising a first electrical contact positioned on the first surface of the array of VCSELs and a second electrical contact positioned on the second surface of the array of VCSELs. The array of VCSELs is arranged to form a two-dimensional array of VCSELs where light emits through a plurality of emission windows in a direction perpendicular to a first surface. A trench is located on the second surface of the array of VCSELs, which is opposite to the first surface of the array of VCSELs. The trench electrically isolates the array of VCSELs from an electrical contact region located on the second surface. An electrical transmission line electrically connects the first electrical contact positioned on the first surface of the array of VCSELs and the electrical contact region located on the second surface. A printed circuit board includes one or more electronic circuits. The array of VCSELs is surface mounted on the printed circuit board. The printed circuit board can include electrically conducting paths on at least two levels for connecting one or more electronic circuits to at least one array module. In various embodiments, the at least one electronic circuit includes at least one of a current driver, an image sensor, a camera, a controller, and a processor. The illuminator module can also include a transparent carrier substrate positioned on the first surface of the array of VCSELs that includes an electrical contact layer having a plurality of windows that are aligned to the plurality of emission windows. In various embodiments, the illuminator module can be configured to perform at least one of motion recognition, gesture recognition, and three-dimensional sensing.

According to another aspect of the present invention, an illuminator includes a plurality of VCSELs forming a monolithic two-dimensional array of VCSELs where light emits through a plurality of emission windows in a direction perpendicular to a first surface an array. The VCSELs include a first electrical contact layer positioned on the first surface of the array of VCSELs. A transparent carrier substrate is positioned on the first electrical contact layer. A second electrical contact is positioned on the second surface of the array of VCSELs, which is opposite to the first surface of the array of VCSELs. A trench is located on the second surface of the array of VCSELs. The trench electrically isolates the array of VCSELs from an electrical contact region located on the second surface. An electrical transmission line electrically connects the first electrical contact positioned on the first surface of the array of VCSELs and the second electrical contact region located on the second surface. A printed circuit board includes one or more electronic circuits. The printed circuit board includes electrically conducting paths on at least two levels for connecting one or more electronic circuits to at least one array of VCSELs. The array of VCSELs is surface mounted on the printed circuit board. The at least one electronic circuit comprises at least one of a current driver, an image sensor, a camera, a controller, and a processor. In various embodiments, the illuminator module performs at least one of motion recognition, gesture recognition, and three-dimensional sensing.

Certain preferred and exemplary embodiments of the present invention, together with further advantages thereof, will now be more particularly described in greater detail by way of example only, in the following detailed description, taken in conjunction with the accompanying drawings, which are exemplary. The skilled person in the art will understand that the drawings, described below, are for illustration purposes only. The drawings are not necessarily to scale, emphasis instead generally being placed upon illustrating principles of the teaching. In the drawings, like reference characters generally refer to like features and structural elements throughout the various figures. The drawings are not intended to limit the scope of the Applicants' teaching in any way.

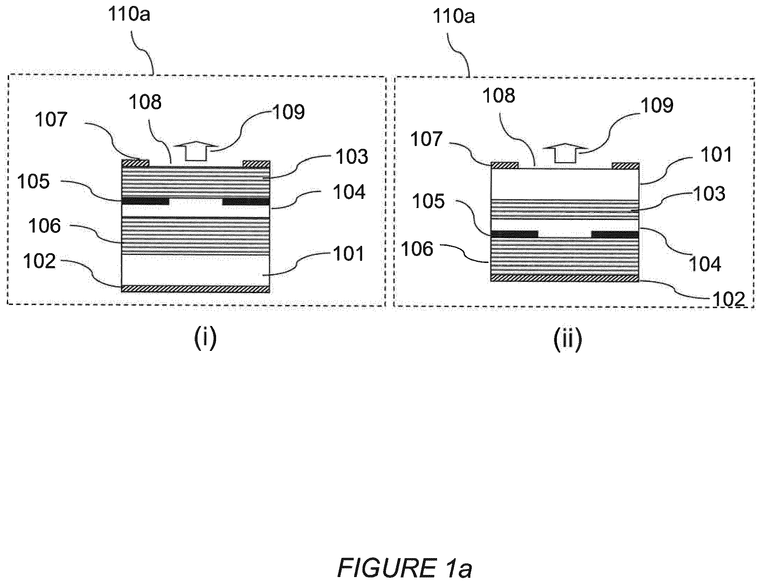

Figure 1a is a schematic representation of a VCSEL device configured in (i) top illumination mode and (ii) bottom illumination mode.
Figure 1 b is a schematic representation of an extended cavity VCSEL, (i) using a top emitting VCSEL cavity and (ii) a bottom emitting VCSEL cavity.
Figure 1c is a schematic representation of an external cavity VCSEL device, (i) using a top emitting VCSEL cavity, (ii) using a bottom emitting VCSEL device cavity.
Figure 1d is a schematic representation of an external cavity VCSEL module using a third mirror bonded to the bottom of a top emitting VCSEL device.
Figure 1e shows representations of two mirror VCSELs or extended cavity VCSELs (i) and external cavity VCSELs (ii) in two dimensional array configurations with a plurality of VCSEL devices.
Figure 2a shows wrap around bonding pads incorporated in configuring a VCSEL array optical surface mount module for an illuminator system.
Figure 2b shows a VCSEL array disposed on a submount with wrap-around pads on four sides. Two opposite wraparounds connect the pad for the VCSEL bottom pad and the other opposite wrap-around pads connect to two pads for wirebonding two sides of the VCSEL top pad.
Figure 3 shows a VCSEL array disposed on a submount having a plurality of via holes for configuring an optical surface mount module for an illuminator system.
Figure 4 shows a VCSEL array disposed on a via submount with one large pad for bonding to the VCSEL array bottom pad and a side pad surrounding the VCSEL array for wirebonding to multiple sides of the VCSEL array. The pads are connected to pads on the underside of the submount with vias.
Figure 5 shows plan and side views of the arrangement in Figure 4.
Figure 6 shows different arrangements for the side pads in Figures 3 and 4 which provide wirebonding to 2, 3 or 4 sides of the VCSEL array.
Figure 7 shows a VCSEL array and an electronic module co-located on a submount to configure a high-speed optical surface mount module for an illuminator system.
Figure 8 shows VCSEL array including a beam shaping optical component for configuring an optical surface mount module for an illuminator system.
Figure 9 shows a VCSEL array and a high-speed electronic module on a common PCB platform for configuring a high-speed surface mount module for an illuminator system.
Figure 10 shows a VCSEL array and a high-speed electronic module connected using high-speed transmission line.
Figure 11 shows a plurality of VCSEL arrays co-located on a common submount for creating larger VCSEL arrays.
Figure 12 shows an enclosed high-power and high-speed illuminator system including optical and electronic modules and high-speed transmission line connectors on a common PCB platform.
Figure 13 is a schematic representation of a VCSEL array chip constructed on a common substrate having surface mountable metal contacts configured having respectively, a) and b) front and back contacts located on opposite surfaces and, c) and d) front and back contacts located on same surface.
Figure 14 is a schematic representation of a VCSEL array chip including an integrated microlens array.
Figure 15 is a schematic representation of a surface mountable VCSEL array module, a) with the substrate, b) without the substrate, and c) with a gold bump contact, respectively.
Figure 16 is a schematic representation of a surface mountable VCSEL array module: a) without a substrate bridge, and b) with a substrate bridge, respectively.
Figure 17 is a schematic representation of a surface mountable VCSEL array module with surface mountable gold bump contact a) without a substrate bridge, and b) with a substrate bridge, respectively.
Figures 18a, 18b and 18c represent VCSEL array modules configured with additional optical components for various beam shaping functions.
Figure 19 is a schematic representation of an array of VCSEL array chips bonded to a transparent carrier substrate respectively, in a) electrically isolated configuration and b) electrically connected together in a series configuration.
Figure 20 is a schematic representation of surface mounted VCSEL array optical modules encapsulated on a) a wrap around thermal submount, b) a low inductance via hole submount, and c) on a printed circuit board co-located with driver electronics (not shown), respectively.
Figure 21 represents an optical illuminator module comprising four VCSEL array module chips showing respectively, a) top planar view, b), c) and d) cross section views through different projections of the illuminator module.
Figure 22 is a schematic representation of VCSEL array module chips arranged respectively, in a) a linear array, and b) in a side-by-side linear array.
Figure 23 is a schematic representation of VCSEL array module with circular emission areas comprising respectively, in a) a VCSEL array module with four quarter-circle emission areas, and b) a VCSEL array module with a combination of a circular emission area and a group of concentric half-rings.
Figure 24 represents respectively, a) an optical illuminator module, b) cross section view of the module, and c) performance characteristics.
Figure 25 shows a) an exemplary air cooled high-power optical illuminator module comprising 9 VCSEL array module chips, and b) a schematic cross section view of the optical illuminator.
Figure 26 shows exemplary liquid cooled optical illuminator modules comprising respectively, a) a side-by-side VCSEL array module chip, b) a circular VCSEL array module chip, and c) a cross section view of the module;
Figure 27 schematically shows a surface mounted optical illuminator module co-located with an electronic circuit on a thermal submount: a) planar view, b) and c) cross section views, respectively.
Figure 28 shows a schematic cross section view of a surface mounted optical illuminator module co-located with an electronic circuit on a multi-level printed circuit board.
Figure 29 shows a schematic planar view of a surface mounted optical device comprising an optical illuminator module and an optical sensor module surface mounted with other electronic circuits on a common printed circuit board.
Figure 30 is a schematic representation of a motion detection apparatus comprising a surface mounted optical device including an optical illuminator module configured according to this invention.
Figure 31 is a schematic depicting principles of a motion detection apparatus using a surface mounted optical device including an optical illuminator module configured according to this invention.

Reference in the specification to "one embodiment" or "an embodiment" means that a particular feature, structure, or characteristic described in connection with the embodiment is included in at least one embodiment of the teaching. The appearances of the phrase "in one embodiment" in various places in the specification are not necessarily all referring to the same embodiment.

It should be understood that the individual steps of the methods of the present teachings may be performed in any order and/or simultaneously as long as the teaching remains operable. Furthermore, it should be understood that the apparatus and methods of the present teachings can include any number or all of the described embodiments as long as the teaching remains operable.

The present teaching will now be described in more detail with reference to exemplary embodiments thereof as shown in the accompanying drawings. An element not shown in any particular embodiment is not be construed as precluded from the embodiment unless stated otherwise. Different aspects presented separately in the embodiments are intended to provide a broader perspective of the invention. While the present teachings are described in conjunction with various embodiments and examples, it is not intended that the present teachings be limited to such embodiments. On the contrary, the present teachings encompass various alternatives, modifications and equivalents, as will be appreciated by those of skill in the art. Those of ordinary skill in the art having access to the teaching herein will recognize additional implementations, modifications, and embodiments, as well as other fields of use, which are within the scope of the present disclosure as described herein.

A laser illuminator (or illuminator) system is disclosed which has numerous advantages over current technology for many applications and is ideally suited for applications, such as three-dimensional (3D) imaging and gesture recognition illuminating system. The illuminator comprises single VCSELs or VCSEL arrays arranged in a module that has high thermal conductivity and includes high-speed electronics circuit such as a current driver. The parasitic elements of the driver circuit are reduced by low inductance sub-assembly design that is suitable for surface mounting to a PCB including high-speed transmission lines to connect the VCSEL or VCSEL array to high-speed driver electronics. The VCSEL arrays disclosed in this invention may be surface mounted directly to a heat sink or a heat sink region optionally included in the PCB, for rapid heat dissipation during high-power operation. Furthermore, optical elements are provided for shaping the optical output beam or emission from the VCSEL-optical output may be modified for individual VCSEL elements or for the entire array.

In another embodiment, the illuminator comprises VCSEL array(s) bonded to a transparent carrier substrate (carrier substrate hereinafter) which seals the emission surface and also provides a robust support. One advantage of the surface mountable packaging described herein is to avoid wire or ribbon bonding of VCSEL arrays that may become a cause of device failure over long run and that increase module costs. The emitting or non-emitting surface of the VCSEL or VCSEL arrays may be integrated with electronic circuit(s) to electrically connect illuminator module to a drive and/or control circuit(s) on a circuit board using standard surface mounting methods.

The carrier substrate described herein is designed to optionally include optical components such as microlenses, diffusers, etc. The VCSEL array with the carrier substrate may be adapted for surface mounting on a circuit board or a submount as the application demands. The optical illuminator as described herein does not require intricate alignment of optical components with individual VCSELs in the array, thereby is readily adaptable for high-throughput manufacturing.

### VCSEL Array Devices

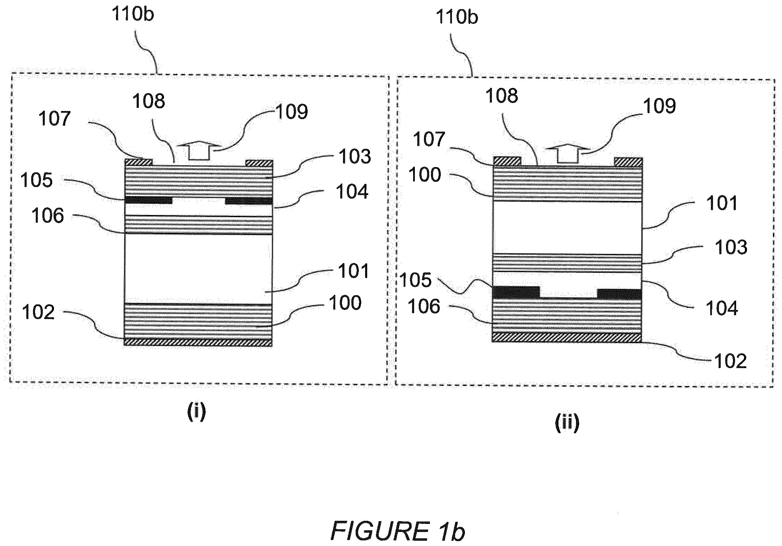

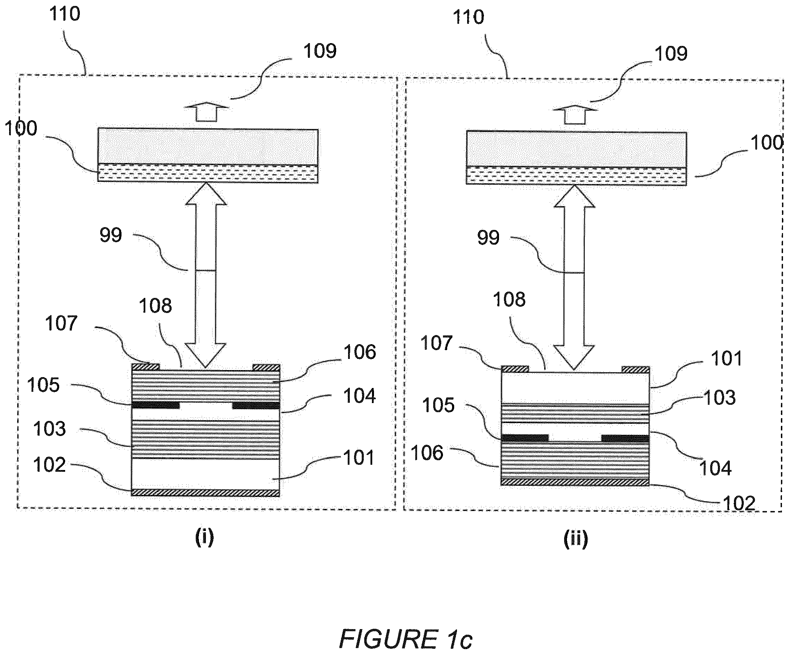

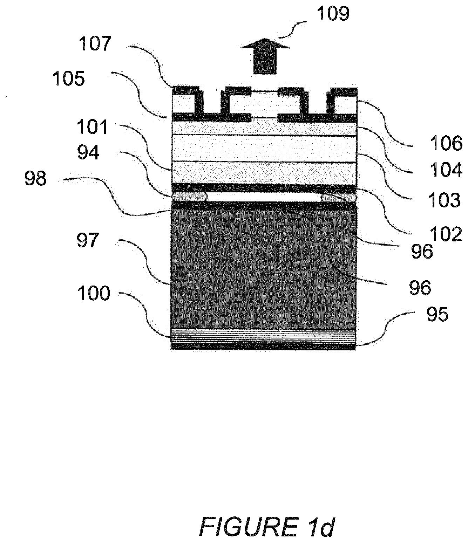

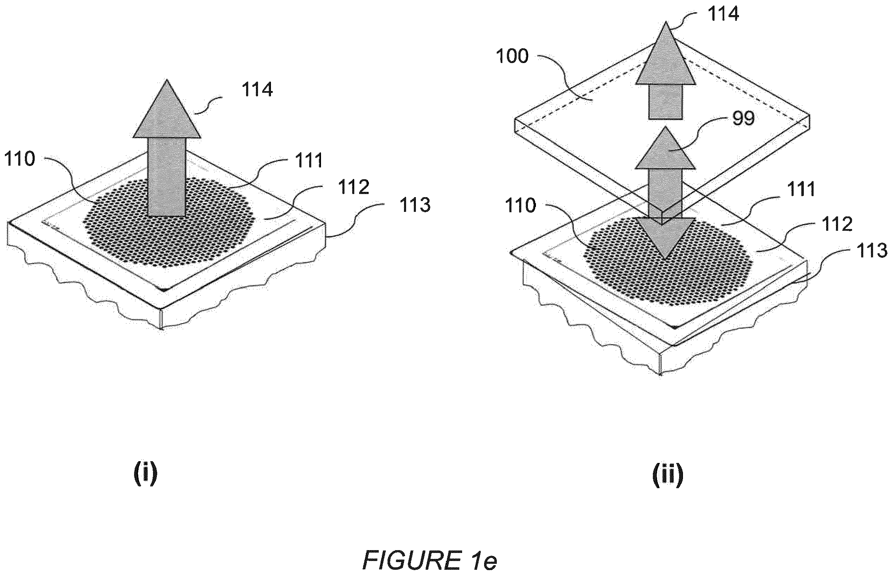

Referring now to Figures 1a, 1b, 1c, 1d and 1e, there it shows a typical VCSEL and VCSEL arrays used for various illumination applications. Identical elements having similar functions in the devices shown in Figures 1 are labeled with same reference numerals and the same description applies. More specifically, two mirror self lasing VCSEL devices shown in Figures 1a(i) and 1a(ii) are constructed on a substrate 101 including a first electrical contact layer 102 (a first terminal). A light emitting region 104 which is a semiconductor gain medium is disposed between two reflectors 103 and 106. The reflectors can be of various types such as distributed Bragg gratings, including dielectric or semiconductor; gratings, including semiconductor, dielectric or metal; or reflecting metal. A second electrical contact layer 107 (a second terminal) is formed on a surface opposite to that of the substrate contact 102. A current confinement aperture 105 controls the flow of drive current to the light emitting region and also determines the shape of emission beam, as has been described in United States Patent Application No. 13,337,098, Seurin etal., filed December 24, 2011, which is assigned to the present assignee.

In the following description, the reference to a "top end," "top electrical contact," and "first surface" of the device is in reference to an emission surface. Accordingly, the emission end of a device is referred to herein as the "top end" and the electrical contact to the emission end of the device is referred to herein as the "top contact." The non-emission end of the device is referred to herein as the "bottom end" or "second surface" and the electrical contact to the non-emission end is referred to herein as the "bottom contact" in the exemplary embodiments throughout, unless stated otherwise.

More specifically, the top emission device shown in Figure 1a(i) has the emission surface 108 located opposite to the substrate end of the device, whereas in the bottom emitting device shown in Figure 1a(ii), the emission surface 108 is located on the substrate side. Accordingly, in Figure 1a(i) the bottom and top terminals are 102 and 107 comprise the substrate end and the active layer end, respectively, whereas in Figure 1a(ii), the bottom and top terminals 102 and 107 is the active layer end, and the substrate end, respectively. It should be noted that the bottom emitting device shown in Figure 1a(ii) is mounted with the substrate side up such that the light emission in the devices shown in Figures 1a(i) and 1a(ii) are in an upward direction (arrow 109). And while the devices are shown with their respective substrates, it is a common practice to reduce the thickness of the substrate, or completely remove the substrate for efficient heat dissipation.

Modified forms of the VCSEL have been developed to obtain improved or other more desirable output characteristics, for example, higher power in a single mode. Figure 1b shows two examples of extended cavity VCSEL devices which use a 3 mirror cavity to obtain such characteristics. Figure 1b(i) uses the top emitting VCSEL structure which is similar to the device described in Figure 1a(i) except for the following modifications. The bottom reflector 106 is made partially reflecting and a third reflector 100 is fabricated on the bottom surface of the substrate. The combination of reflectors 100 and 106 result in high reflectivity, when they are in a designed phase relation ship, resulting in the desired VCSEL laser operation. The output 109 is transmitted by the top reflector 103 and is in the same upward direction.

Figure 1b(ii) uses the bottom emitting VCSEL structure which is similar to the device described in Figure 1a(ii) except for the following modifications. The top reflector 103 is made partially reflecting and a third reflector 100 is fabricated on the top surface of the substrate. The combination of reflectors 100 and 103 result in increased reflectivity, when they are in a designed phase relationship, resulting in the desired VCSEL laser operation. The output 109 is transmitted by the third reflector 100 and is in the same upward direction.

Another embodiment of the three mirror configuration, the external cavity VCSEL, is shown in Figures 1c (i), (ii) and Figure 1d using a third mirror 100 which is separate from the VCSEL device substrate. Figures 1c (i) and (ii) show two forms of this external three mirror cavity VCSEL device using top emitting and bottom emitting VCSELs respectively. Figure 1c(i) uses the top emitting VCSEL structure which is similar to the device described in Figure 1a(i). The VCSEL device is very similar except that the reflection coefficient of the top reflector 106 is reduced. A third reflector 100 is located above the top surface 108 of the VCSEL device at a design distance such that the combined reflection of reflectors 106 and 100 provide a high reflectivity to produce laser action with the desired output characteristics. The resonant cavities result in laser action 99 between the three mirrors and is output 109 through the third mirror 100 at the top.

Figure 1c(ii) uses the bottom emitting VCSEL structure which is similar to the device described in Figure 1a(ii). The VCSEL device is very similar except that the reflection coefficient of the top reflector 103 is reduced. A third reflector 100 is located above the top surface 108 of the VCSEL device at a design distance such that the combined reflection of reflectors 103 and 100 provide a high reflectivity to produce laser action with the desired output characteristics. An antireflection coating is applied to the top surface 108 to eliminated losses in the cavity due to reflection. The resonant cavities result in laser action 99 between the three mirrors and is output 109 through the third mirror 100 at the top.

Figure 1d shows a 3rd example of an external cavity VCSEL in which the output is taken from one of the VCSEL device reflectors 106. It also gives some detail on how the third reflector can be attached to the VCSEL device to form a robust compact module. This configuration and design has a number of manufacturing advantages including the fact that the whole assembly can be performed at the wafer level to produce a multitude of modules on the wafer and then the completed modules are separated out by dicing.

The module shown in Figure 1d uses a top emitting device as described in Figure 1a(i). Although, as would be evident to one skilled in the art, it could also be built using a bottom emitting device as described in Figure 1a(ii). The bottom reflector 103 is made partially reflecting to form the middle reflector in a three mirror cavity. The VCSEL substrate 101 has an antireflection coating 96 applied to the surface area where the optical beam traverses and is metalized 102 to form the bottom contact in other surface regions. The third reflector is deposited on a transparent substrate 97 and has an antireflection coating 96 applied to the opposite surface. That same surface has metallization 98 applied to the areas outside the region where the optical beam traverses. This third reflector on substrate is then soldered 94 to the bottom of the VCSEL device to form a monolithic module. The third reflector 100 is located below the bottom surface of the VCSEL device at a design distance, determined by the thicknesses of the VCSEL and transparent substrates 101, 97 such that the combined reflection of reflectors 103 and 100 provide a high reflectivity to produce laser action with the desired output characteristics. The resonant cavities result in laser action between the three mirrors and is output 109 through the VCSEL top mirror 106.

It can be appreciated by those skilled in the art that instead of a single VCSEL device 110, an array of multiple VCSEL devices, both self emitting and 3 mirror cavity, may be constructed on a single substrate as shown in Figure 1e(i) and 1e(ii). More specifically in Figure 1e(i), a VCSEL array device 112 shown therein comprises a two-dimensional array 111 of a plurality of VCSEL devices (each dot represents a VCSEL device 110) similar to that shown in Figure 1 a or Figure 1b constructed on a common substrate 112. All the VCSEL devices in the array are electrically connected to the substrate which functions as a first common terminal of the array. In order for the VCSELs to emit collectively, the second electrical contact of each VCSEL in the array is connected using a common metallization on the array surface which functions as a second common terminal of the array.

All the VCSEL devices emit collectively in an upward direction shown by the arrow 114 in this example. For the ease of description, the VCSEL array 112 as shown in Figure 1e will be referred as VCSEL array chip (or array chip hereinafter). In this particular example, the VCSEL devices are arranged to form a circular array chip. It can be appreciated that array chips may be configured in any regular geometric pattern or random shape. The array chip 112 can be mounted on any kind of a thermal submount 113 that is described in the United States Patent Application No. 13,337,098, Seurin et al., filed December 24, 2011.

In a similar manner, the external cavity VCSEL described in Figure 1c or 1d can be configured into an array of multiple VCSEL devices constructed on a common substrate as shown in Figure 1e(ii). In the devices described in Figure 1c, the separate external mirror is a single third mirror 100 located at the correct distance above the top of the VCSEL array substrate. The top or bottom emitting VCSEL devices with the reduced reflectivity mirror 106 or 103 respectively are fabricated in a common substrate 112. The third mirror 100 is located at the design specified distance from the VCSEL array 112 so that the combined cavity of the three mirrors produces laser action 99 in each VCSEL device with the desired characteristics. The output beam from the array of VCSELs 114 is transmitted out in the upward direction out from mirror 100.

In the case of the VCSEL module described in Figure 1d, as is described above, the assembly can be made in wafer form with a single third mirror substrate bonded to a VCSEL device substrate wafer which contains a multitude of VCSEL devices. The layout of the VCSEL wafer can be configured as an array of VCSELs modules by using the appropriate fabrication masks and processes. Thus, instead of dicing individual device modules, many modules comprising an array of devices can be diced from the external cavity VCSEL wafer assembly.

This description shows a few examples of 3 mirror extended cavity and external cavity VCSEL devices and array modules. It should be apparent to anyone skilled in the art that other arrangements of 3 mirrors can be used and that combinations of these configurations to provide four mirror VCSEL cavities in single devices and arrays of devices can also be produced.

In the remaining discussion the term VCSEL arrays, VCSEL array devices or elements refers to any of the above types of VCSEL devices described above including VCSELs, extended cavity VCSELs and external cavity VCSELs.

### VCSEL Array Surface Mount Module:

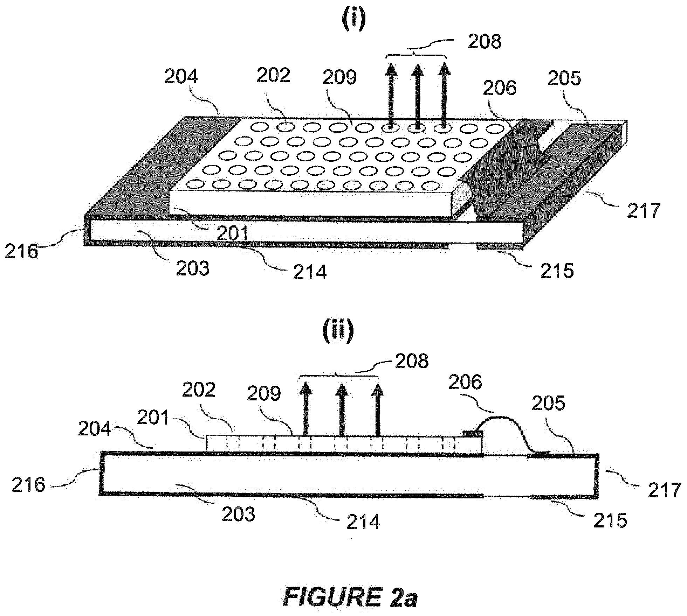

In Figure 2a is shown a plan view 200a and a corresponding cross-section view 200b, respectively, of an example optical module. Identical parts in the two views are labeled with same reference numerals for ease of description. The device shown is specifically, a two dimensional array 209 comprising a plurality of VCSEL elements 202 (only one is labeled for clarity) is constructed on a common substrate 201. The plurality of VCSELs in this example also may be of the various types described above in Figure 1a, 1b, 1c, 1d and 1e, as long as they are mounted to emit in the same direction (upward in this example) as shown by a representative set of arrows 208 for clarity.

First electrode of each VCSEL (located underside of the substrate 201 in this example) is connected together to a common first terminal of the array. Second electrode of each VCSEL is connected together (top surface of the array 209) to a common second terminal of the array. As mentioned earlier, the substrate of the array is the bonding surface and the surface of the array is the emitting surface in this example as well. The common substrate, also the common first terminal of the array in this example, is bonded to a bonding pad 204 on a submount 203 having high thermal conductivity such that the heat generated in the VCSEL array is rapidly spread away and dissipated. Multiple wire bonds or a common wide bonding ribbon 206 provides a very low inductance connection to the common second terminal from the VCSEL array emitting surface to a second bonding pad 205 located on the common submount.

The bonding pads 204 and 205 although located on the same surface of the common submount, are electrically isolated. In this example the bonding pads 204 and 205 are wrapped around the respective edges 216 and 217 of the submount 203, and connected to corresponding set of large area bonding pads 214 and 215 on an opposing surface under the submount such that the VCSEL array is in effective thermal contact with the heat sink (not shown in Figure 2a) on which the submount is bonded. This aspect is more clearly seen in the cross-section view (ii). In this example, electrical connections to the VCSEL array are made on the bottom side of the thermal submount for surface mounting the array. For example, the large area bonding pads may be solder bonded to correspondingly designed connector pads on a PCB. Common electrode connections to all VCSELs allows operating the devices together using a common drive current thereby, facilitating all the VCSELs to emit simultaneously to generate high output power. In this example the VCSEL array is electrically connected via the large area bonding pads 214 and 215 to corresponding pads on a PCB for example, to a high-speed current driver circuit.

In the example described above, only one set of bonding pads 204 and 205 are shown which are common between all the VCSELs in the array. It practice, many bonding pads are co-located on the same surface of the submount. For some applications it is advantageous to connect different sections of the VCSEL array to different drive current circuits so as to operate them in a programmable fashion. Different sections of the VCSEL array may be connected to separate bonding pads on the same thermal submount which are individually wrapped around the respective edges of the thermal submount and connected to a corresponding pad on the underside of the thermal submount.

As mentioned earlier, the thermal submount is placed on a heat sink (not shown in Figure 2a) for efficient heat dissipation. In this example the thermal submount having large area bonding pads underneath, placed on a heat sink or on a heat sink integrated in a PCB results in very low thermal resistance path between the VCSEL array and the heat sink. At the same time the parasitic elements and in particular the inductive impedance of the electrical path is reduced due to large area contact pads, which is a definite advantage for high speed pulse operation of the VCSEL array.

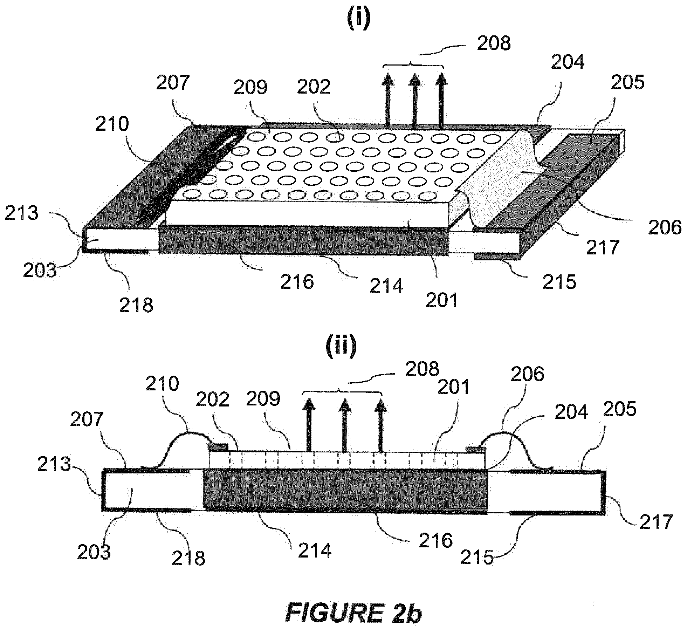

A variation of the arrangement of Figure 2a is shown in Figure 2b for situations when very high speed operation of the VCSEL or VCSEL array is required. The submount metallization is modified so that the bonding pad 204 on which the VCSEL 209 is bonded has wrap-around connections on two opposite sides 216 of the submount 203. The wrap-around connections connect to the large bonding pad 214 on the underside of the submount. In addition there are two side pads 205 and 207 on opposite sides of the VCSEL array orthogonal to the wraparound connections 216. There are also two bonding pads 215, 218 on the underside of the submount electrically isolated from the large pad 214. The two side pads 205 and 207 have wrap-around connections to the underside pads 215 and 218 respectively. The two side pads 205 and 207 are then wirebonded 506 and 510 to the top pad of the VCSEL array. This arrangement of VCSEL array on the submount can then be directly surface mounted on a PCB with matching solder pads to the submount bonding pads 215, 214 and 218. The provision of multiple parallel wraparound connections greatly reduces the electrical inductance and resistance between the VCSEL array and the PCB enabling very high speed pulsing or modulation operation of the VCSEL array.

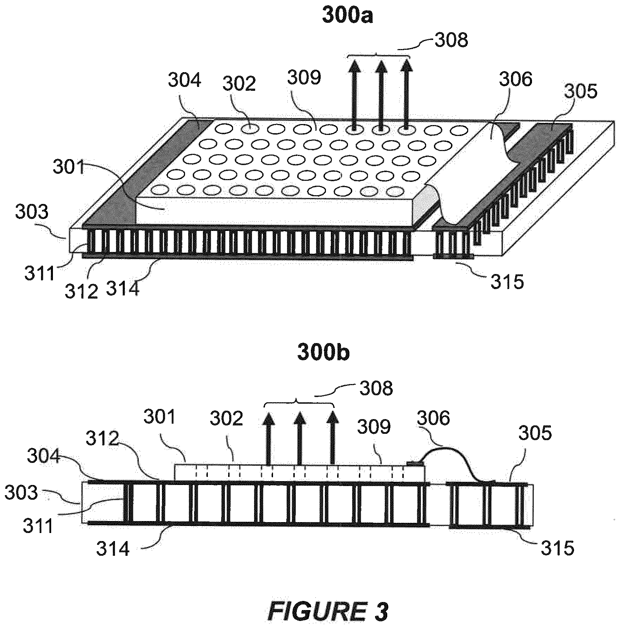

In another embodiment shown in Figure 3, an optical module is configured using a submount that is different from the thermal submount described in reference with Figure 2a and 2b. The module shown in a plan view 300a and a corresponding cross-section view 300b, respectively, is similar to the module described in reference with Figure 2. More specifically, a VCSEL array 309 including a plurality of VCSELs 302 (only one is labeled for clarity) disposed on a common substrate 301, is bonded to a bonding pad 304 located on one surface of a submount 303 such that, one electrode of the VCSEL array (located underside of the array) is in electrical contact with the bonding pad 304. A second electrode located at the top emitting surface of the VCSEL array is wire or ribbon bonded to a second bonding pad 305 located on the same surface of the submount 303 and electrically isolated from the bonding pad 304. The VCSEL array emits parallel beams of light shown by a representative set of arrows 308.

Similar to the example shown in Figures 2a and 2b, the submount 303 shown in Figure 3 may be constructed using a high thermal conductivity material. However, in this embodiment, it is not necessary to have a high thermal conductivity material for the submount for dissipating heat away from the VCSEL array. Instead, the submount in this embodiment further includes a plurality of via holes (sometimes also referred to as thru holes) 311 (only one identified from a side-view). This aspect of the submount design is more clearly shown in the cross-section view 300b where identical parts from the view 300a are labeled with the same reference numerals. Individual via holes 311 (only one shown from the top for clarity) are coated or filled with an electrically as well as thermally conducting material to connect 312 the bonding pads 304 and 305 to corresponding set of large area bonding pads 314 and 315, respectively, located on the underside of the submount.

Materials that may be used to coat or fill the via holes include but are not limited to, metals such as copper, silver or gold that exhibit high electrical and thermal conductivity such that the heat generated in the VCSELs is rapidly dissipated to a heat sink (not shown in Figure 3). As mentioned earlier in reference with the examples described in reference with Figures 2a and 2b, the submount may be placed on a heat sink and/or on a PCB for electrically connecting the VCSEL array to a high-speed current driving circuit. In addition to higher thermal conductivity, the plurality of via holes also provide very low inductance electrical contact between the bonding pads 304 and 305 to the respective large area contact pads 314 and 315 and to a high current driver circuit on the PCB.

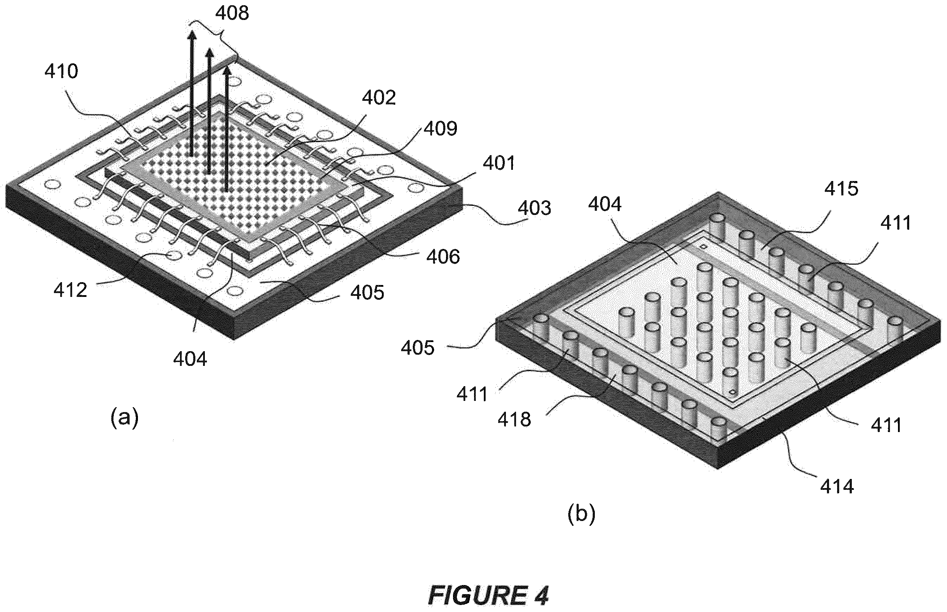

A further alternative configuration of the VCSEL array on via submount in Figure 3 is shown in Figure 4 for situations when very high speed operation of the VCSEL array is required. The VCSEL array 409 bottom pad is bonded to the large pad 404 on the top of the submount 403. There is a corresponding bonding pad 414 on the underside of the submount. Electrical and thermal connections 412 are made from the top pad 404 to the underside pad 414 using a multitude of vias 411 whose properties were described earlier.

A side bonding pad 405 is located around the periphery of the VCSEL array and electrically isolated from the large bonding pad 404. Wirebonds or similar connections 406 are made between the bonding pad 405 and the top VCSEL pad on all four sides of the VCSEL array 409. Two or more bonding pads 415 and 418 are located on the underside of the submount beside and electrically isolated the bonding pad 414. These bonding pads 415, 418 are electrically and thermally connected 412 to the side bonding pad 405 on the top of the submount through the vias. Other configurations of the bonding pads 415, 418 can be envisioned, by persons skilled in the art, including having more than two pads, provided direct connections can be made from them to the upper bonding pad 405 using vias 411. This arrangement of VCSEL array on the submount can then be directly surface mounted on a PCB with matching solder pads to the submount bonding pads 415, 414 and 418. The provision of multiple parallel connections to the VCSEL array greatly reduces the electrical inductance and resistance between the VCSEL array and the PCB enabling very high speed pulsing or modulation operation of the VCSEL array.

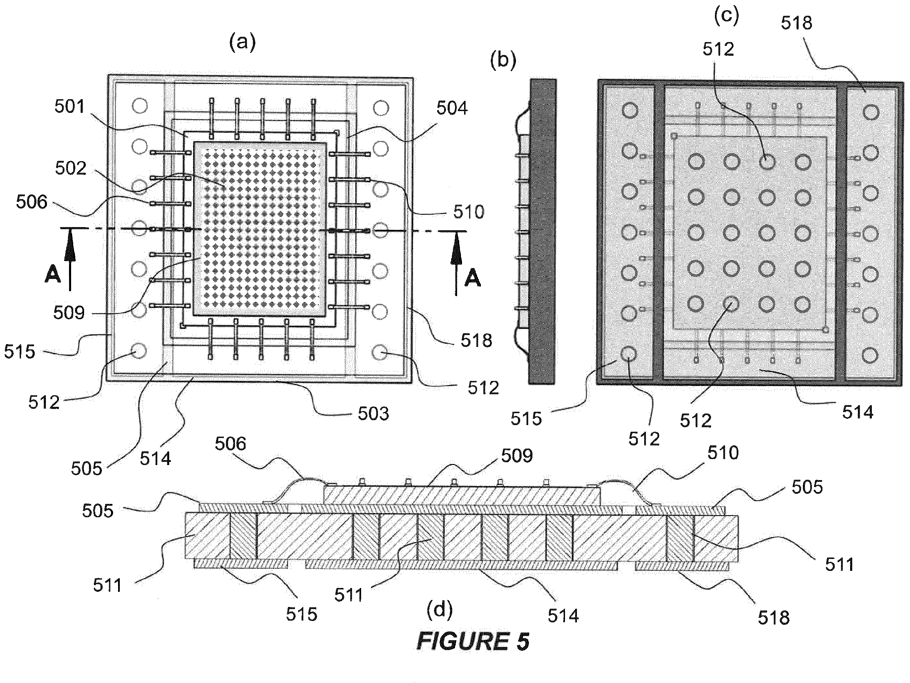

An alternative view of the arrangement in Figure 4 is shown in Figure 5. The plan view (a) gives more details about the submount upper pads 504 and 505 and the wirebond connections 506, 510 to the VCSEL array 509. The view (b) is an edge view showing the VCSEL array, submount and the wirebonds. The plan view (c) is the underside of the submount showing the bonding pads 515, 514, 518 and the layout of via connections 512 to the upper and underside bonding pads. Figure 5(d) shows a cross section of the VCSEL array on submount providing more details on the via connections 511 between the upper and lower submount bonding pads.

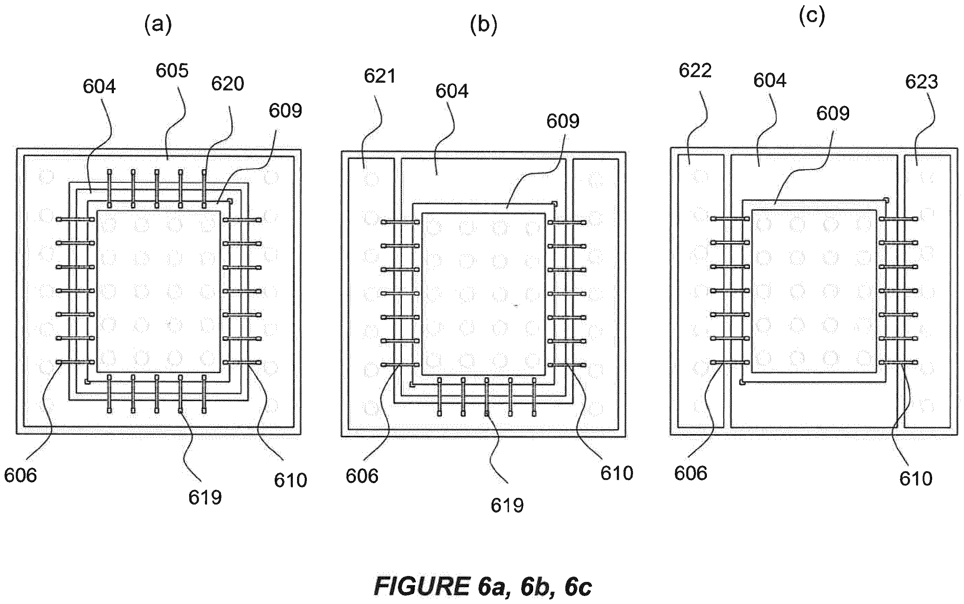

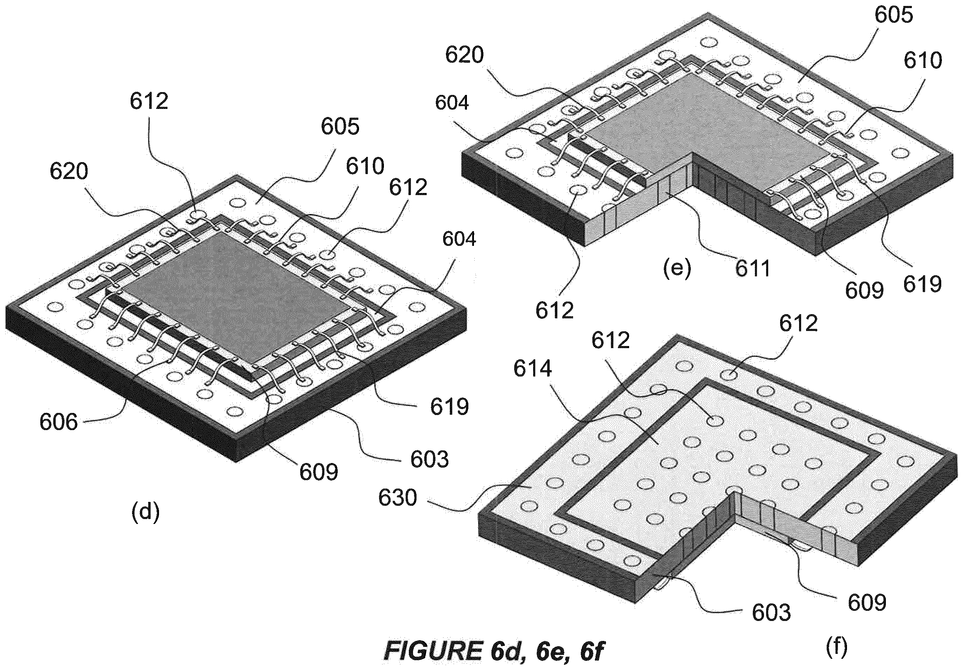

Although only one layout for the submount side bonding pad was shown, other layouts can be envisioned as would be obvious to one skilled in the art. Figure 6 shows the prior layout (a) and two other layouts (b) and (c). In all three instances the underside bonding pad layout is the same. Although this underside bonding pad layout can also be different as discussed earlier. In (b) the side pad 621 is placed around three sides of the VCSEL array 609 and wirebond connections 606, 610 and 619 made to three sides of the VCSEL array top pad. The VCSEL array bottom pad is bonded to the upper large pad 604 which for this arrangement can be extended in the one direction that no longer contains the side pad. This layout can have benefits such as in testing to provide a pad area for probe testing etc.

Figure 6(c) shows a layout with two side pads 622, 623 on opposite sides of the VCSEL array. These are connected to the two underside pads 615, 618 shown in Figure 5. Wirebond connections 606, 610 are made from the VCSEL array top pad to the two side pads 622, 623 respectively. The VCSEL array bottom pad is bonded to the upper large pad 604 which for this arrangement can be extended in two directions that no longer contain the side pads. This layout can have benefits such as in testing to provide a pad area for probe testing; it also provides benefits in assembly by simplifying various bonding operations etc.

The optimum layout for high speed is shown in Figure 6d, 6e and 6f. In this configuration the VCSEL array 609 bottom pad is bonded to the large central pad 604. The VCSEL array top pad is wirebonded on all four sides 606, 610, 619 and 620 to a ring pad 605 around the VCSEL array. The bottom side of the submount 603, as shown in 6f, has solder bonding pads 614 and 630 which are opposite and dimensionally match the top pads 604 and 605 respectively. The respective pads 604, 614 and 605, 630 are connected 612 with multiple electrically and thermally conducting vias 611. This arrangement provides the most direct connection resulting in minimum inductance and thus allows very high speed pulsing or modulation of the VCSEL array.

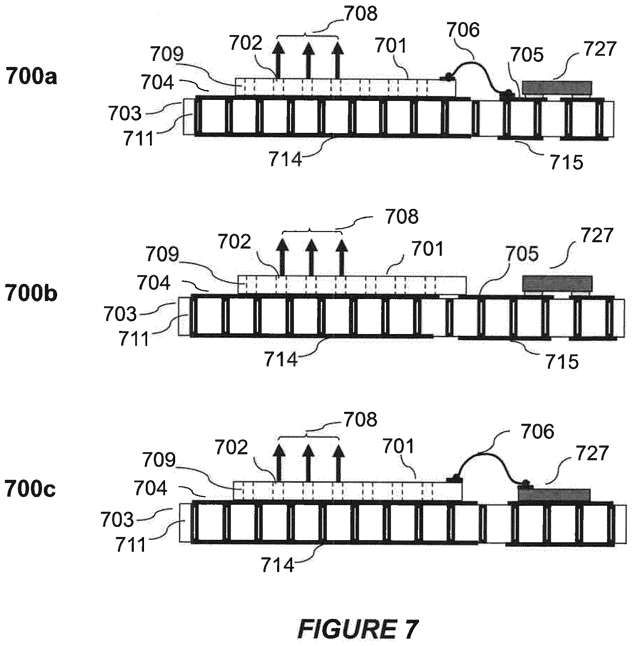

In one embodiment, a high-speed optical module is configured using a VCSEL array and an electronic circuit for example, an integrated circuit or an electronic chip (electronic module hereinafter) is optionally bonded to the same thermal submount as shown in Figure 7. The VCSEL array and the thermal submount are similar to the ones shown in Figures 3, 4, 5 and 6 where identical or equivalent parts in Figures 3, 4, 5, and 6 are labeled with same reference numerals. For a more detail description, reference is made to the earlier description associated with Figures 3, 4, 5 and 6. One terminal of the VCSEL array is bonded to a bonding pad 704 on the thermal submount 703. The electronic module 727 including at least one current driver circuit and optional additional circuits for control and monitoring purposes is bonded to the thermal submount using either flip-chip bonding or conventional surface bonding as shown respectively in schematic views 700a, 700b and 700c.

In the schematic view 700a, the VCSEL array 709 is electrically connected using a wire or ribbon bonding 706 to the electronic module 727 on the common bonding pad 705. An alternative way of electrically connecting the VCSEL array to the electronic module is shown in the schematic 700b. In this method the electronic module is mounted in a flip chip configuration on the same surface of the submount on which the VCSEL array is bonded. The electrical connection between the VCSEL array and for example a current driver circuit is made using a transmission line 705. The transmission line 705 may be further connected to active or passive impedance matching components. More specifically, a via hole (not shown) located on the VCSEL array's top emitting surface and the substrate 701 provides a conducting path between the terminal of the VCSEL array and the transmission line 705 shared with the electronic module 727. In the schematic view 700c, the electronic module 727 is bonded on the substrate side to a bonding pad on the thermal submount and is electrically connected to the terminal of the VCSEL array using a wire or wide ribbon bonding 706.

It will be apparent to those skilled in the art that while these exemplary embodiments show only one set of bonding pads and one set of VCSEL array and electronic module on the thermal submount for clarity, each thermal submount may include many more bonding pads to incorporate more VCSEL arrays and electronic modules for configuring larger optical modules, for example. One advantage of including the electronic module on the same submount is to facilitate high-speed operation of the VCSEL array by reducing the parasitic elements for example, the inductive impedance of the current drive circuit.

While this aspect of the invention is explained using a submount with plurality of via holes, the principles are equally applicable to the wrap around submount design described earlier in reference with Figure 2a and 2b. Those skilled in the art will recognize that different bonding pads co-located on the submount may be wrapped around respective edges of the submount and connected to a corresponding set of large area bonding pads on an opposing surface under the submount so as to connect different VCSEL arrays and/or electronic modules.

### Beam Shaping and Emission Patterns:

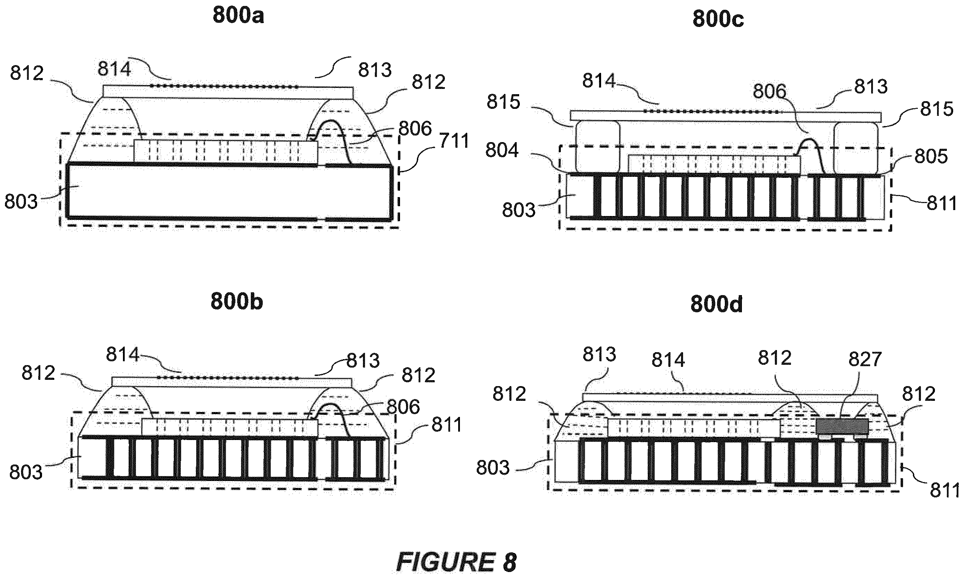

The output beam profile may be reshaped or modified to obtain a desired emission pattern by placing one or more optical components placed in front of the VCSEL output beam. As an example, the optical component may just be a transparent window or may further include one or more beam shaping elements. Referring to Figure 8, there it shows VCSEL sub-assemblies 800a, 800b and 800c including external optical components. Identical parts in the separate views are labeled with same reference numerals and will be described in general. More specifically, parts enclosed in a dashed box 811 collectively represent a VCSEL array sub-assembly described earlier in reference with Figures 2, 3, 4, 5, 6 and 7 and will not be described again. In configurations 800a and 800b a ring of bonding material 812 such as solder or epoxy, is placed on the submount around the edge of the VCSEL array and an optical component 813 is attached to the bonding ring.

As an example, when additional beam shaping is not required, the optical component is just a transparent window. The optical component is aligned at a pre-determined height above the VCSEL sub-assembly 811 so as to encapsulate the electrical wire or ribbon connector(s) 806 located on the top emitting surface of the VCSEL array for additional mechanical support. Furthermore, the encapsulation material hermetically or non-hermetically seals the VCSEL array together with the optical component. When beam shaping is required, the optical component may further include one or more beam shaping elements or arrays of said elements, collectively shown as 814 in Figure 8.

The beam shaping elements 814 may be mounted or formed on the optical component 813. The optical component including the beam shaping elements is placed at a predetermined height above the VCSEL sub-assembly 811 and laterally aligned with the VCSEL array, such that the beams emitted from the VCSEL array pass through the optical elements 814 at a correct position and distance required for the desired beam shaping operation. Selection of the optical elements is predetermined according to the beam shaping or emission pattern requirement desired for a particular application. Beam shaping elements may include but are not limited to, lenses, micro-lenses, apertures, beam diffusers, etc. or arrays of one or more of these elements. In case different parts of the array need different type of beam shaping, different beam shapers can be added in a single layer or multiple levels of beam shapers can be added by stacking them on top of each other. Furthermore, the beam shaping elements, such as micro-lenses or diffusers may be integrated with the VCSELs by fabricating them on top of VCSELs optical component or may be external to the VCSELs or to the optical component.

In an alternative embodiment shown as 800c, the optical component 813 is attached to the VCSEL array sub-assembly using solder bump technology. The optical component 813 can be mounted by using epoxy bumps as shown in 812 all around the VCSEL array. The optical component may include one or more beam shaping elements 814 or arrays of said elements on one surface. In this embodiment the optical component 813 also includes ready to solder metal pads 815 deposited on the surface that does not include the beam shaping elements. The thickness of the solder metal pads is determined by the height where optical elements have to be placed for the required beam shaping operation. The optical component is laterally aligned with the bonding pads 804 and 805 on the submount 803 such that emission from the VCSEL array passes through the beam shaping elements at a position and distance required for the desired beam shaping operation. The solder or epoxy around the VCSEL array and the attached optical component also provides sealing for the VCSEL array to protect it from external elements.

One embodiment of an optical module including a high-speed electronic module is shown in a schematic view 800d. In this embodiment the dashed box 811 represents a high-speed optical module similar to one shown in Figure 700b. In this example, a bonding material 812 for example, a solder or an epoxy, is placed on the submount around the VCSEL array as well as the electronic module 818, with an optical component 813 to encapsulate the entire optical module. The optical component may just be a transparent window or may include optional additional optical elements 814 or arrays of said elements, when beam shaping is required. The solder or epoxy around the VCSEL array and the attached optical component also provides sealing for the VCSEL array to protect it from external elements. While this embodiment is described in reference with the optical module 700b shown in Figure 7, the description is equally pertinent for other optical modules 700a and 700c shown in Figure 7 as well.

### High-Speed Optical Module:

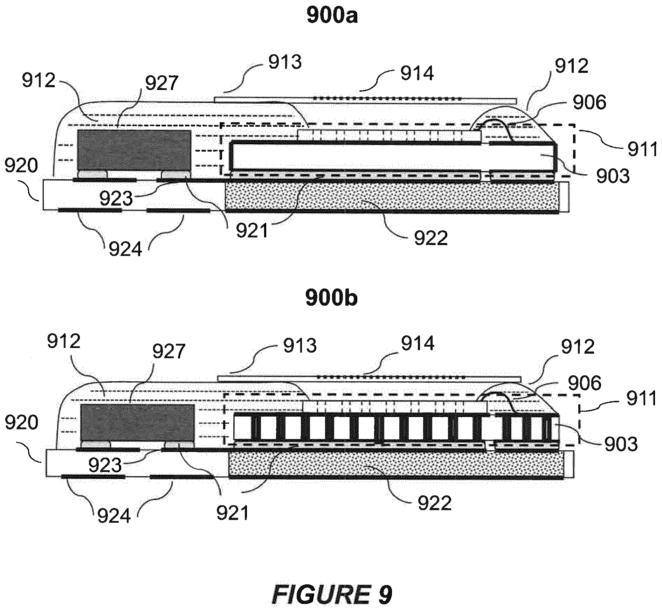

A VCSEL array together with the beam shaping optical elements as described earlier, may be used to configure a high-speed optical module shown in Figure 9. Exemple of a high-speed module shown in schematic view 900a and exemplary embodiment of a high-speed module shown in schematic view 900b are similar in principle to the high-speed optical module described in reference with Figure 7. Common features of exemplary high-speed optical modules 900a and 900b are labeled with similar reference numerals and will be described together for a clear understanding. More specifically, a typical high-speed module has an optical module 911 represented by a dashed box and an electronic module 927. The high-speed optical modules shown in 900a and 900b are substantially similar in almost all respects, to optical modules described earlier in reference with Figures 2, 3, 4, 5 and 6, respectively, and include a VCSEL array bonded on a thermal submount 903. The submount in 900a is different from the submount in 900b in that the latter includes a plurality of via holes described earlier in reference with Figures 3, 4, 5 and 6.

In addition to the optical module, the exemplary high-speed module includes a high-speed electronic module 927 including at least one high-speed current driving device. The optical and electronic modules are surface mounted on a PCB 920 using a thermally conductive bonding medium 921 such as a solder, an epoxy and other materials that are well known in the art for surface bonding electronic chips to a PCB in a high-speed electronic circuits. The PCB further includes one or more high-speed transmission lines 923 (only one labeled) on one surface and a plurality of ground planes 924 (only a few shown) on an opposing surface under the PCB. The electronic module is electrically connected to the optical module using high-speed transmission line 923 for example, to drive, modulate and control the VCSEL arrays at high speed. The PCB may optionally include a heat sink region 922 to which the optical module is directly bonded for efficient heat dissipation.

The optical module in the exemplary high-speed sub-assembly includes an optical component 913 including one or more beam shaping elements 914 or arrays of such elements, described earlier in reference with Figure 8. The optical component is attached to the sub-assembly using a bonding material 912 such as a solder or epoxy, disposed on the optical module submount 903 as well as on the PCB such that the optical component is aligned to the VCSEL array on the optical module and the electronic module is encapsulated on the PCB. It can be appreciated that the arrangement for the high-speed sub-assembly described here is only exemplary and other arrangements for assembling the optical module with the electronic module that may occur to those skilled in the art are within the purview of this invention.

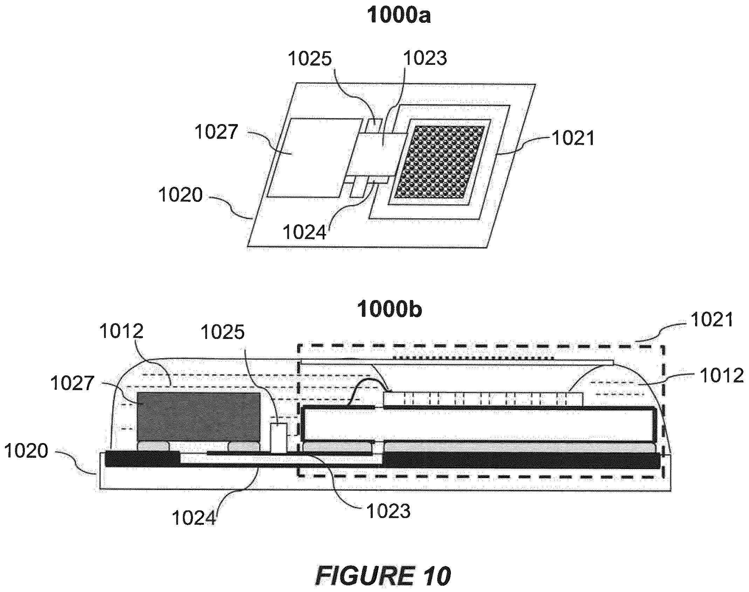

Figure 10 shows an exemplary arrangement for connecting an optical module to an electronic module on a PCB using high-speed transmission lines. More specifically, the plan view 1000a and a corresponding cross-section view 1000b, respectively, show a PCB 1020 including an optical module 1021 (shown as a dashed box in 1000b) and an electronic module 1027 connected by a high-speed transmission line 1023 and a ground plane 1024 on either side (only one side is labeled for clarity). In addition, active or passive impedance matching elements 1025 (only one is labeled for clarity) are disposed on either side of the transmission line. Those skilled in the art will be able to appreciate that the transmission line in this example may be stripline micro stripline or co-planar type, and are well known in the art. Although not labeled explicitly in the figure, the optical module as shown in this example includes the beam shaping elements that are attached to the module using a bonding material as described earlier in reference with Figure 8.

Although the optical module used to configure the examples shown in Figure 9a and 10 uses the arrangement shown as 800a in Figure 8, these examples will work equally well with the arrangements shown as 800b, 800c or 800d in Figure 8 where the thermal submount includes a plurality of via holes. In fact, embodiments or examples using different combinations and sub-combinations of these basic modules will be apparent to those skilled in the art and different embodiments or examples can be constructed within a broad framework of the description presented in earlier sections. One advantage of including high-speed transmission line on the same PCB platform together with the optical and electronic modules is to reduce parasitic circuit elements and particularly the inductance, for high speed operation of the VCSEL array. In addition, other electronic components for example, pre-fabricated programmable components for high speed control operations may optionally be included on the same PCB platform.

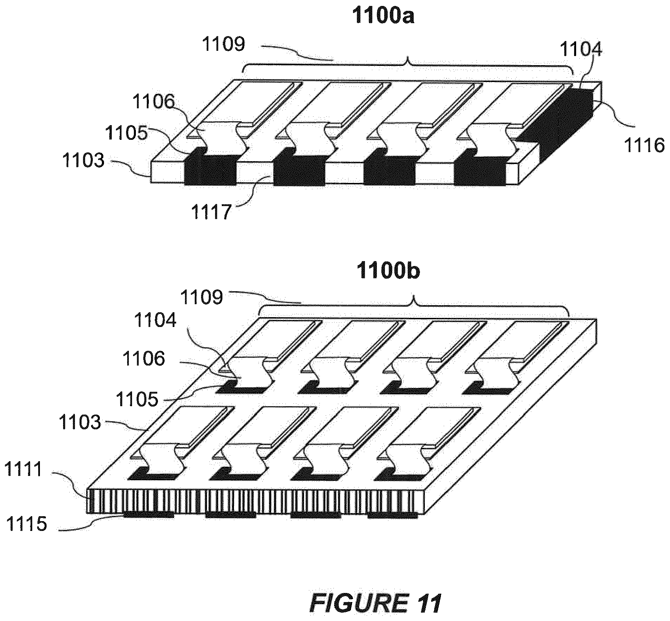

While all the embodiments and examples described earlier are shown with a single VCSEL array. In practice, a plurality of VCSEL arrays may be co-located on the same submount. Exemplary configurations are shown in Figure 11 where schematic views of a one dimensional and a two dimensional array of VCSEL arrays are 1100a and 1100b, respectively are shown to be co-located on the same submount 1103. More specifically, 1100a shows a 1 x N array of VCSEL arrays (collectively labeled as 1109) on a common submount. The submount includes a plurality of bonding pads 1104 and 1105 wrapped around one or more nearest edges 1116 and 1117, respectively, to connect to a corresponding set of large area bonding pads located on the opposing surface under the submount (not shown in Figure 11). This example may be adapted to construct a 2 x N array. Another embodiment including a 2 x N array of VCSEL arrays is shown in 1100b on a submount having a plurality of via holes 1111 to connect each bonding pad on a surface of the submount 1103 (only 1104 and 1105 are shown for clarity) to a corresponding set of large area bonding pads (only one 1115, is shown for clarity) on an opposing surface under the submount 1103. The embodiment shown in 1100b is more suitable for adapting to M x N arrays.

Each VCSEL array may be connected separately using one or more ribbon bonds (1106), (only one shown for each device for clarity) or collectively to one or more current driver circuits. Furthermore, VCSELs in different arrays may have different current confining aperture structure(s) to facilitate different emission patterns. Those skilled in the art will be able to recognize that VCSELs in different arrays may be connected in a modular fashion. For example, all the arrays on the submount may be connected together or separately, may be operated or programmed to operate in desired mode and/or desired combinations thereby, providing a large number of possibilities for generating different illumination power and emission patterns.

### Illuminator System:

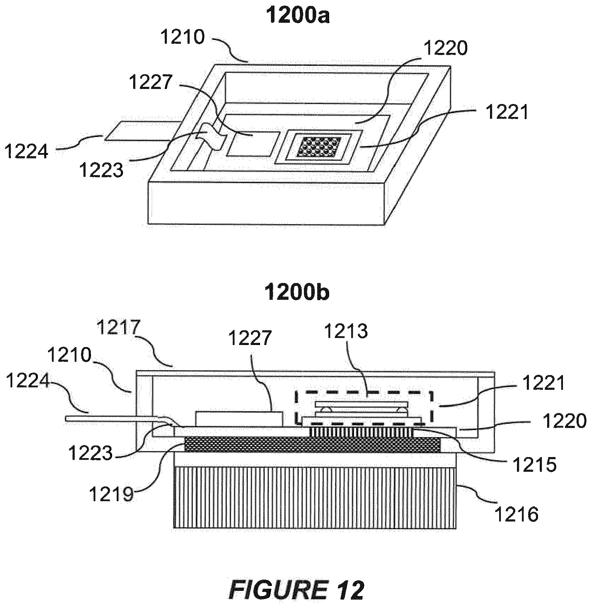

A combination of different modules described earlier may be used to configure a high-speed, high-power illuminator system shown in Figure 12. An isometric view 1200a shows an overall picture of an illuminator system. Details of the illuminator system will be better understood in reference with a corresponding cross-section view 1200b. Similar elements in both views are labeled with same reference numerals to avoid repetitive description. More specifically, the illuminator system shown in 1200a and 1200b comprises an optical module 1221 directly bonded to a PCB 1220 together with a high-speed electronic module 1227. The electronic module includes at least one current driving device to supply drive current to the optical module. The electronic module includes other devices for providing one or more control functionalities to the optical module. In this embodiment, the electronic module may be addressed remotely through an external controller (not shown) using a high-speed link comprising a transmission line 1223 (stripline or microstrip) located on the PCB, and an external connector 1224 located on the housing 1210 of the illuminator.

The optical module comprises a VCSEL array disposed on a thermal submount described earlier in reference with Figures 2a, 2b, 3, 4, 5, 6, 7, 8, and 9. Each optical module may include one or more VCSEL arrays. Furthermore, the optical module may include one or more beam shaping elements or arrays of said elements similar to those described in reference with Figures 8, 9 and 10. The optical module is bonded on a bonding pad 1215 on the PCB using a large area bonding pad located on the underside of the submount as has been described earlier in reference with Figures 2, 3, 4, 5, 6 and 7. The bonding pad on the submount may be placed directly on a heat sink region optionally included in the PCB, such that the submount under the VCSEL array is bonded to the heat sink region of the PCB so as to facilitate direct thermal contact between the VCSEL array and the heat sink region. The PCB in turn is bonded to the thermally conducting base 1219 of an enclosure 1210, thereby providing an efficient thermal conducting path between the VCSEL arrays and an external heat sink 1216 of the illuminator enclosure.

A transparent cover 1217 is provided on an opposing end from the base of the enclosure, to hermetical or non-hermetical sealing of the enclosure. Instead of including the beam shaping elements on the optical module similar to that described in reference with Figure 8, the transparent cover may alternatively be used to provide beam shaping elements. The distance between the optical module and the transparent cover is accordingly adjusted so as to achieve a desired beam shape from the optical module. As mentioned earlier, the illuminator may include more than one VCSEL array for high-power and/or large area illumination. The multiple VCSEL arrays can be connected together electrically in series or in parallel for them to work in a synchronous fashion.

For clarity and simplicity of discussion, the exemplary modules are described using a single VCSEL or an array of VCSELs constructed on a single substrate. Those skilled in the art will be able to appreciate that in practice, several individual VCSELs or arrays may be constructed on a single large area substrate. Each device or array on a substrate may be connected to separate current drivers or connected to a common current driver, depending upon the required output power. While the exemplary embodiments described above use a regular two-dimensional array of VCSELs constructed on the same substrate, any array of VCSELs regular or irregular, may be created by arranging single high-power VCSELs in desired patterns, for example, a linear or one-dimensional array, an irregular two dimensional array etc.

Similarly, each module described earlier in reference with Figures 2a, 2b, 3, 4, 5, 6 and 7 is described to be disposed on an individual thermal submount. In practice, more than one module may be disposed on a single thermal submount. Larger two dimensional VCSEL arrays may be created by arranging one dimensional arrays or smaller two-dimensional arrays connected together on a common bonding pad or on separate bonding pads on the thermal submount. Advantageously, small size of VCSELs facilitates closely packed arrays thereby, resulting in a very uniform and speckle free illumination pattern.

Furthermore, different arrays may be programmed to be operated separately or collectively using one or more driving current circuits depending upon the output power requirement. Each array may be programmed for synchronous, asynchronous, continuous, pulsed or sequential operation. Packaging the optical and electronic module on the same PCB using high-speed transmission lines allows pulse operation of the VCSEL array at high speed (of the order of Gb/s) and can be modulated using external controller. Furthermore, different sections of the VCSEL array may be configured to be operated or modulated at different rates.

The description provided here is intended to cover a broad framework of constructing and operating high-speed and high-power laser illuminators using VCSEL arrays in a modular fashion. Those skilled in the art will be able to appreciate that the modular characteristics of configuring and programming the VCSEL arrays offers a wide range of choices in operating speed and control, for generating different illumination patterns required for different types of applications, a few of which are mentioned earlier in the background art section.

### Surface Mount VCSEL Array Chip

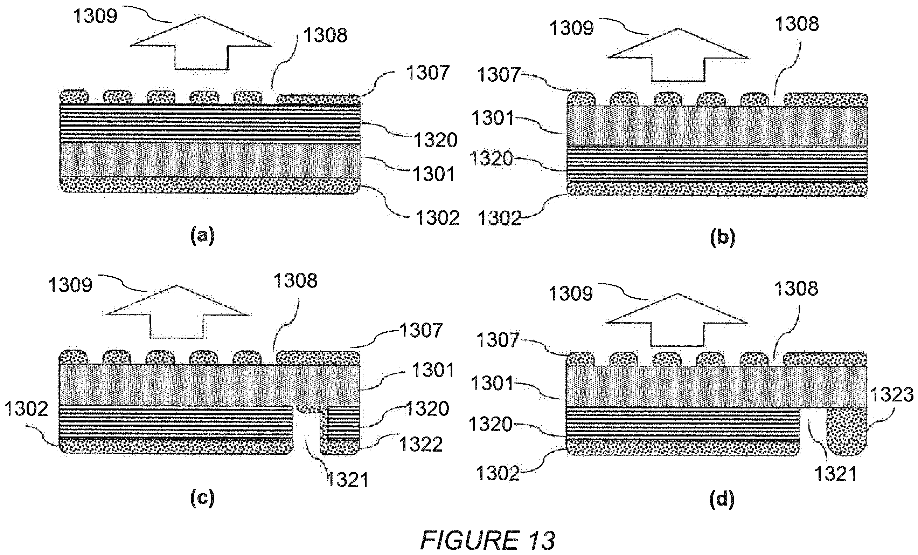

It is noted that the two terminals of the traditional VCSEL array chip are located on two opposite ends (emission and non-emission ends) of the array chip. This aspect is more clearly depicted in cross section schematic views shown in Figure 13.

Referring now to Figures 13a-13d, an array chip is constructed on a common substrate 1301 in each instance. For clarity of representation, the VCSEL array active layer comprising the light emitting region, the current confining region and the reflectors is collectively represented as 1320. In the top emission configuration of the array chip shown in Figure 13a, the bottom contact 1302 on the non-emission side forms a common first terminal of the array chip. The bottom contact is a continuous metallization layer which is electrically connected to the conducting substrate (1301) in this example.

The top contact disposed on the active layer on the emission side forms a common second terminal of the array chip. The top contact comprises a continuous metallization layer having emission windows 1308 (only one labeled for clarity) created by selective etching (or selective deposition). The metallization between the windows form the top metal contact pads 1307 (only one labeled) for making electrical connections. Each window (1308) is aligned with a corresponding current confinement aperture of a VCSEL located directly below.

In the bottom emission configuration shown in Figure 13b, the array chip is placed upside down such that the non-emission side contact 1302 electrically connected to the active layer forms a common first terminal. The top metallization layer on the emission side is disposed on the substrate 1301 and has a plurality of windows 1308 (only one labeled). The metallization layer remaining between the windows form electrical contact pads 1307 (only one labeled) for making electrical connections. Each window (1308) is substantially aligned with a corresponding current confinement aperture in the active layer located directly underneath. The top metallization layer forms a common second terminal for the array chip. The array chip in bottom emission mode is upside down, such that the emission is from the substrate end in an upward direction (1309). However, the example shown here in this configuration is not to be construed as limiting.

In the array chips shown in Figures 13a and 13b, the first and second terminals are located on the opposite sides of the emission surface. In order to facilitate surface mounting, it is desirable to have both the electrical terminals as planar contacts located on the same side. Figures 13c and 13d show two embodiments where the first and second terminals are located on the same side. More specifically, in the bottom emission mode, the array chip is to facilitate surface mounting of the array chip. The array chip is mounted in the bottom emission mode in the embodiments shown in Figures 13c and 13d, (similar to the embodiment shown in Figure 13b); however, it should not be construed as a limitation.

In the embodiment shown in Figure 13c, a window 1321 or a trench is created by selectively removing a part of the bottom contact 1302 and the active layer 1320 underneath. An additional metallization layer 1322 is selectively deposited on the non-emission side of the substrate 1301. The metallization layer 1322 is supported on the part of the active layer that is physically and electrically separated from the rest of the active layer of the array chip by the window 1321. The conductive substrate having contact on both sides in this configuration electrically connects the metallization layer 1322 to the top contact 1307 through current flow in the substrate. Thus, the two terminals of the array chip (1322 and 1302) having substantially the same height, are co-planar on the same side of the array chip, thereby facilitating surface mounting of the array chip.

The embodiment shown in Figure 13d is slightly different; a portion of the bottom contact 1302 and the active layer underneath is selectively removed. An electro-plated gold bump 1323 substantially equal in height to the active layer 1320 and the contact layer 1302, is then deposited on the non-emission side of the substrate 1301 leaving a gap 1321 between the array chip active layer and the gold bump 1323. Thus the conductive substrate having contact on both sides in this configuration electrically connects the gold bump 1323 to the top contact 1307 through current flow in the substrate. Therefore the two terminals of the array chip are co-planar on the same side. In the configurations described in Figures 13c and 13d, the gap 1321 may optionally be filled with an insulating or a polymeric material using a process step known as 'planarizing' in the art.

Although the concept of surface mountable VCSEL array chip is demonstrated using a bottom emitting array chip, the same concept is equally applicable for top emitting array chip. As mentioned earlier, the substrate may be thinned down or entirely removed to reduce absorption of the emitted light in the substrate (in devices where the substrate would absorb the emitted light completely), and for facilitating efficient heat dissipation.

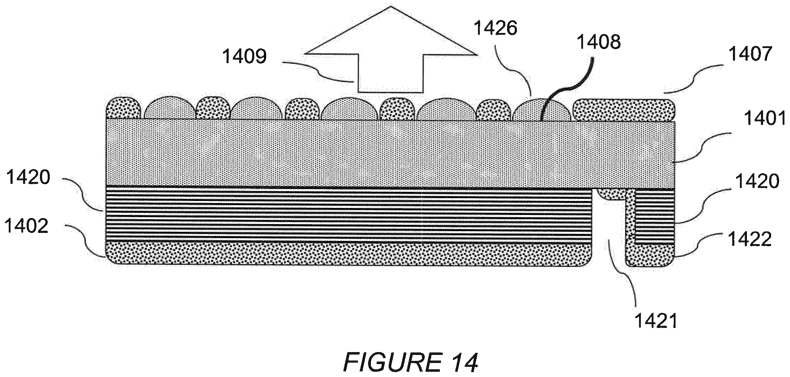

In one variant embodiment shown in Figure 14, additional optical functionality is provided by integrally constructing optical components to a surface mountable VCSEL array chip substantially similar to the one described in reference with Figure 13c. More specifically, in Figure 14, a VCSEL array chip comprises an active layer 1420 disposed on a substrate 1401. Part of the active layer 1420 is selectively removed to create a trench 1421 to facilitate connecting the top electrical contact layer 1407 to an additional metallization layer 1422 on the non-emission side of the substrate.

A microlens array comprising of a plurality of microlenses 1426 is constructed on the emission end of the array chip such that each microlens in the array matches corresponding windows 1408 (only one set is labeled for clarity) on the emission end. The microlens array may be constructed by selectively etching the substrate or by a post processing step. Different options available for post processing steps are well known in the art and will not be described. The height and curvature of the microlenses may be pre-determined to provide a desired functionality for example, beam shaping by focusing or collimating the emission from each VCSEL in the array chip. It is also possible to construct different microlenses having different optical properties in different sections of the array chip.

One advantage of the surface mountable array chip constructed according to this invention is that the manufacturing process is simplified by reducing or eliminating complex alignment steps currently used for creating via holes through the substrate. The invention also provides a means to eliminate wire or ribbon bonding of the top (emission side) contact to a connector pad on the bottom (non-emission) side of the array chip. United States Patent Application No. 13,337,098, Seurin et al., filed December 24, 2011 describes a surface mountable VCSEL array module where the contact from the top emission side of the VCSEL array is connected to a contact pad on a thermal submount on the non-emission side using a wire or ribbon bonding. Those skilled in the art will be able to recognize that the wire or ribbon bonded contacts are often the cause of device failure and also increase costs. The surface mountable array module described in this invention substantially reduces that risk by using only co-planar contacts.

### VCSEL Array Module

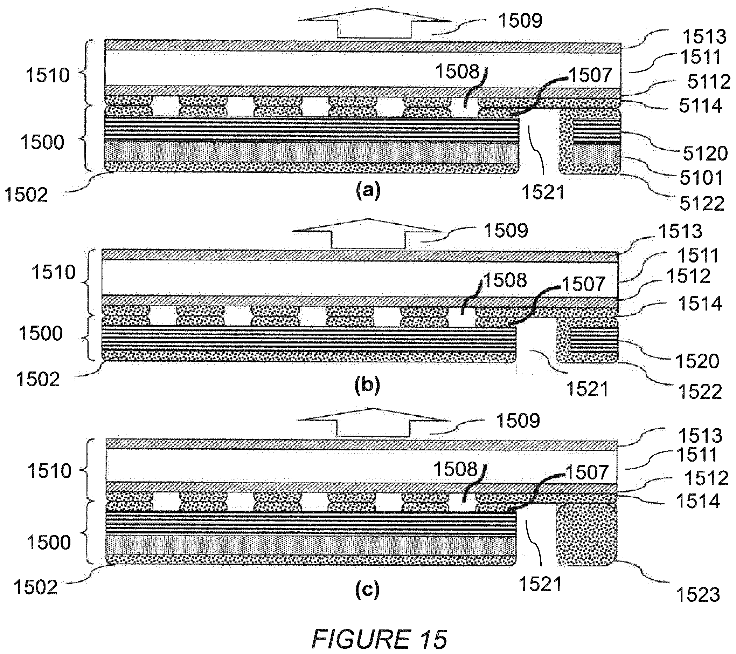

In one embodiment of the invention, surface mountable array chips described in the previous section are used to construct VCSEL array optical module (array module hereinafter). Figure 15 shows an optical module constructed using a top emitting array chip similar to the one shown in Figure 13a. The elements that are identical in different embodiments shown in Figures 15a, 15b and 15c are labeled with the same reference numerals. Referring now to array modules shown in Figures 15a, 15b, and 15c, section 1500 collectively represents an array chip substantially similar to the one shown in Figure 13a.

More specifically, the array chip shown in Figure 15a comprises an active layer 1520 disposed on a substrate 1501. The array chip configured in the top emission mode includes a plurality of emission windows 1508 (only one labeled) opened on a continuous metallization layer leaving the surrounding areas as metal pads 1507 (only one pad labeled) for making electrical contacts on the emission side. The metal pads form a first terminal of the array module. A second section 1510 of the module comprises a transparent carrier substrate 1511 (carrier substrate hereinafter). The bottom and top surfaces of the carrier substrate are coated with antireflection layers 1512 and 1513, respectively. A continuous metallization layer 1514 is disposed over one of the antireflection layers 1512 (in this example). The metallization layer may be selectively deposited using a mask, or selectively removed, to open windows on the metallization layer, while the remaining metallization layer around the windows form metal pads for making electrical; connections and bonding. The windows on the array chip and the carrier substrate may be created using the same mask set, such that the windows and the surrounding pads in the two sections align.

The carrier substrate 1510 is flipped and bonded to the array chip at the metal pads by soldering, for example. However, other methods for bonding such as capillary bonding may also be used. The windows and the surrounding pads in the two sections align upon bonding the two sections. A portion of the active layer and the substrate is selectively removed to create a window or a trench 1521 for connecting the top electrical contact of the array chip to a contact pad on the non-emission side. In an alternative embodiment shown in Figure 15b, after bonding the two sections, the substrate 1501 is thinned, or removed entirely (in this specific example) for more efficient heat dissipation from the VCSEL array.

A continuous metallization layer 1502 is deposited on the bottom non-emission surface, such that part of the window 1521 is without any metallization. An additional metallization layer is deposited to create a contact pad 1522 for providing an electrical contact from top metal pads 1507 to the non-emission side (proximal to the substrate in Figure 15a) of the array chip, thereby forming a first and a second terminal of the array module via the carrier substrate bridge 1514 in the metallization layer. In a different embodiment shown in Figure 15c, a portion of the active layer 1520 is selectively removed to electrochemically plate a gold bump 1523 on the non-emission side leaving a gap 1521 between the active layer and the gold bump, substantially similar to the one described in reference with Figure 13d. The thickness of the gold bump is substantially equal to the thickness of the active layer. In the configurations shown in Figures 15a, 15b and 15c the first and second electrical contacts for the array are in a planar form and located on the non-emission surface. Light from the array module 1509 is emitted through the carrier substrate 1510 which also seals and protects the VCSEL devices located on the array chip.

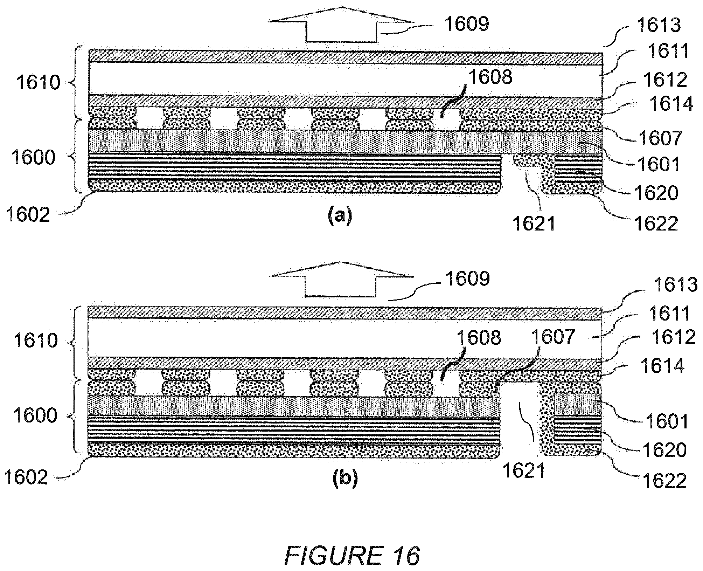

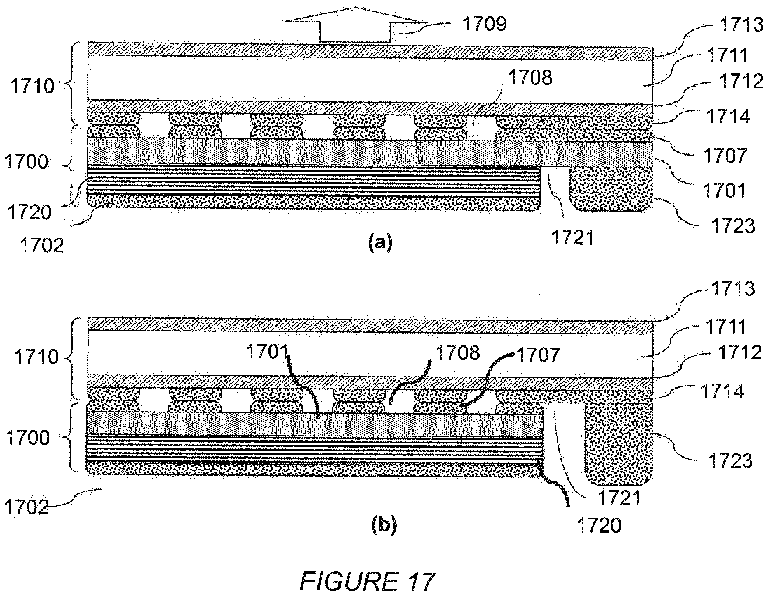

Figures 16 and 17 show exemplary array modules constructed from array chips shown in Figures 13c and 13d, respectively. Reference numerals in Figures 16 and 17 follow the same convention as the reference numerals in Figure 15. Referring now simultaneously to Figures 13, 15, 16 and 17, the array module shown in Figure 16a has an array chip section 1600 bonded to a carrier substrate section 1610 that are substantially similar to the ones described earlier in reference with Figures 15a and 51b.

The reference numerals 1611, 1612, 1613 and 1614 represent elements that are substantially similar to the elements 1511, 1512, 1513 and 1514, respectively, described earlier in reference with Figure 15. That description will not be repeated for brevity.

The array chip in the embodiment shown in Figures 16a and 16b is configured in bottom emission mode and is substantially similar to the one described in reference with Figure 13c. The active layer 1620 is selectively removed to create a trench 1621 in order to deposit an additional metallization layer 1622 to make an electrical connection from the top contact layer 1607 on the emission surface to the non-emission side surface of the device, such that the two planar terminals (1622 and 1602) of the array chip are located on the non-emission side of the substrate in planar form.

The embodiment shown in Figure 16b is substantially similar to the one described in reference with Figure 16a except for the structure of the trench 1621. In this example, the trench is extended all way to the carrier substrate by selectively removing the active layer and the substrate. The additional metallization layer 1622 connects the top metallization layer 1607 of the array chip using the bridge, created by the metallization layer 1614. The metallization layers 1622 and 1602 form the two planar contacts for the array terminals located on the same side of the substrate. In the embodiments shown in Figure 16, the light from the array module is emitted in a vertical direction (relative to the page) shown with the arrow 1609.

Referring now simultaneously to Figures 17a and 17b, the embodiment shown in Figure 17a comprises an array chip section 1700 bonded to a carrier substrate section 1710. The carrier substrate section 1710 is substantially similar to the ones described in reference with Figures 15 and 16 and that description will not be repeated. The elements shown by the reference numerals 1711, 1712, 1713 and 1714 are described earlier in reference with similar elements 1511, 1512, 1513 and 1514 shown in Figure 51. The array chip is configured in the bottom emission mode substantially similar to the one shown in Figure 13d.

More specifically, a portion of the active layer 1720 is selectively removed from the substrate 1701. On the exposed section of the substrate, an electrical contact is made by selectively electroplating a metal layer 1723 leaving a gap 1721 between the active layer and the electroplated region. The electroplated contact layer is located on the same side as the contact layer 1702 and the thickness of the plated region is substantially equal to the thickness of the active layer. The plated region is electrically connected to the top contact layer 1707 via the substrate. The electroplated metal layer 1723 and the non-emission side contact layer 1702 form the two terminals of the array module. Since in this case the substrate 1701 can be conducting and carry the electrical current, the metal layers 1714 and 1707 may not be necessary, and the substrate 1701 may be bonded directly to carrier substrate 1710, using well known techniques such as capillary bonding.

The embodiment shown in Figure 17b is substantially similar to the embodiment shown in Figure 17a and comprises two sections 1700 and 1710, representing an array chip and a carrier substrate section, respectively. The carrier substrate section 1710 includes elements (1711-1714) that are substantially similar to the elements (1711-1714) described in reference with Figure 17a. In addition, the carrier substrate includes an electroplated region 1723 located on a part of the metallization layer 1714.

The carrier substrate section is bonded to the array chip 1710 by aligning the metal pads 1707 with a corresponding metal pad 1714 and pressing them together and in some cases fusing them with heat, such that the windows 1708 align with the windows in the substrate. Soldering techniques can be also used to attach 1707 to 1714. The metal pads 1707 are electrically connected with the electroplated layer via the metal bridge of the metallization layer 1714 on the carrier substrate. The metallization layer 1702 and 1723 form the two terminals of the array module located on the non-emission side of the substrate. The light emission shown by the arrow 1709 is in the vertical direction (with reference to the page) from the top surface of the array chip substrate.

There are several advantages of constructing the surface mountable array modules according to this invention. One advantage is that the top contact on the emission surface is connected to the non-emission side of the module using planar contacts (without wire or ribbon bonding), which reduces the risk of failure considerably. The invention also eliminates the need for the complex alignment steps used in conventional surface mountable devices for the alignment of via holes through the substrate. Furthermore, the array chip is bonded to the carrier substrate using a metal-metal solder or fusion bonding between the pads which is more robust as compared to epoxy bonding often used for this purpose in prior art devices. Other bonding methods such as capillary bonding may also be used. In addition, different sections may be pre-fabricated separately and assembled in a modular fashion in a relatively shorter time, thereby improving throughput in a manufacturing environment and reducing cost. It should be noted that the principles of the invention is described using planar contacts, the same principles may be applied to other surface mountable VCSEL arrays using wire or ribbon bonding. However, those skilled in the art would be able to appreciate the merits of the planar contact options over other connector options as described in the United States Patent Application No. 13,337,098, Seurin et al., filed on December 24, 2011.

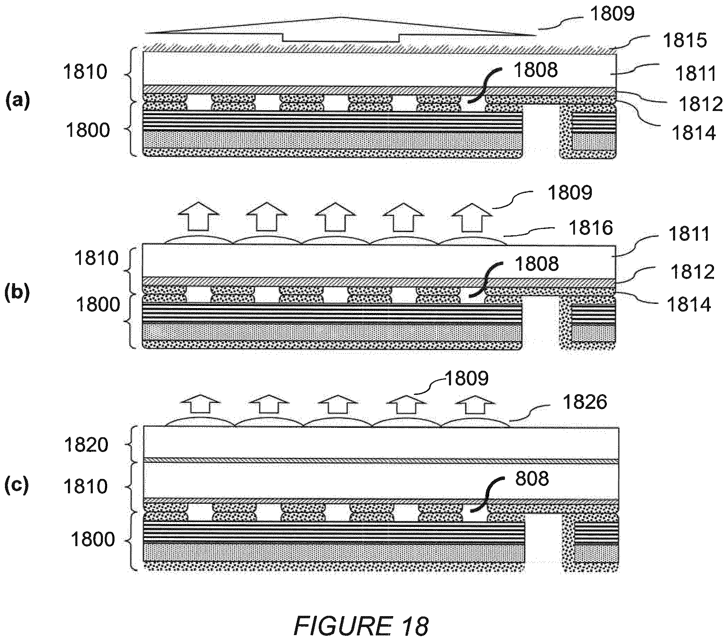

Emission from a VCSEL device is generally (although not always) a Gaussian like narrow beam in the sense that most of the beam's energy is located at the center of its transverse distribution. In many applications and in particular, in an illuminator application it is often desired to shape the output beam of a VCSEL device. United States Patent Application No. 13,337,098, Seurin et al., filed on December 24, 2011 discloses different methods to shape VCSEL output beams. Figure 18 shows a few exemplary embodiments of beam shaping methods that may be used in conjunction with the array modules described in reference with Figures 15, 16 and 17. Each element shown in embodiments 18a, 18b and 18c are labeled using substantially similar reference numerals as in Figures 15, 16 and 17. The elements represented by similar reference numerals will therefore not be described in detail again.

More specifically, the embodiment shown in Figure 18a comprises an array chip section 1800 and carrier substrate section 1810. The array chip section is substantially similar to the one described in reference with Figure 15a. That description will not be repeated. The carrier substrate 1810 comprises a substrate 1811 having one side coated with an antireflection layer 1812. Furthermore, a metallization layer 1814 having windows aligned with the chip array windows 1808 is disposed on the antireflection layer proximal to the array chip. The metallization layer surrounding the windows forming metal pads are used to bond the sections 1810 and 1800. Unlike the optical array described in reference with Figure 15a, the top emission surface of the substrate section is constructed to have an optical element for beam shaping, for example a diffuser 1815 instead of a second antireflection layer (1513 in Figure 15a). As a result, the light 1809 emitted out of the array module is diffused.

In some other applications, in addition to reducing speckle for example, the diffuser is also used to increase the divergence angle of the array to a predetermined number. The embodiment shown in Figure 18a is particularly suitable for an application where a uniform diffused illumination pattern is preferred for example, security illumination for perimeter monitoring, where cameras of certain field of view are used with laser illuminators illuminating the same field of view, or illumination for 3D imaging or gesture recognition, where illumination of a rectangular field of view of certain divergence angle, matching the camera divergence is required. In addition, 1815 may be a diffractive or holographic optical element, for example.

Although the divergence angle of a VCSEL emission is quite small (∼ 10-15°), output from a VCSEL still spreads over a large distance away from the emission surface. As a consequence, the light emitted from the module may not be focused uniformly over a large surface area at a large distance from the illumination surface. In another embodiment of the invention shown in Figure 18b having an array chip 1800 and a transparent carrier substrate section 1811, the top emission surface of the carrier substrate section includes an additional optical element, for example an array of microlenses 1816, each microlens in the array is aligned with a corresponding emission window 1808 on the array chip. One advantage of having individual microlenses is to collimate and reduce the angle of the diverging beam, for example.

The height at which microlenses are disposed above the array chip may be pre-determined and precisely controlled by the thickness of the carrier substrate 1811 for example, such that individual emissions from adjacent VCSELs each collimated using a corresponding microlens, fill up the dark space between the adjacent emissions. As a result, overall emission from the entire array module is distributed uniformly even at considerably large distance away from the array module. This embodiment may be particularly suitable for an application where an array module is configured to pump a solid state gain medium as described in United States Patent Application No. 13,369,581, van Leeuwen etal., filed February 09, 2012.

In an alternative embodiment shown in Figure 18c, which is otherwise identical to the array module described in reference with Figure 15a, an additional optical element including a carrier substrate 1820 having an array of micro-lenses 1826 is disposed above the carrier substrate 1811 and the array module 1800. The microlens array is positioned at a predetermined height where each microlens in the array is aligned with an emission window 1808. One advantage of this embodiment is that a prefabricated microlens array may be added or bonded to an existing array module similar to that shown in Figure 15a, for example.

In general, a carrier substrate may include but is not limited to, glass, sapphire, diamond, etc. Although the principles of this embodiment is described in reference with a top emitting array module, other types of array modules described in other embodiments are not precluded. Furthermore, the basic idea of having additional optical elements is conveyed using a few representative examples. It should not be construed that other types of optical elements suitable for beam shaping are precluded.

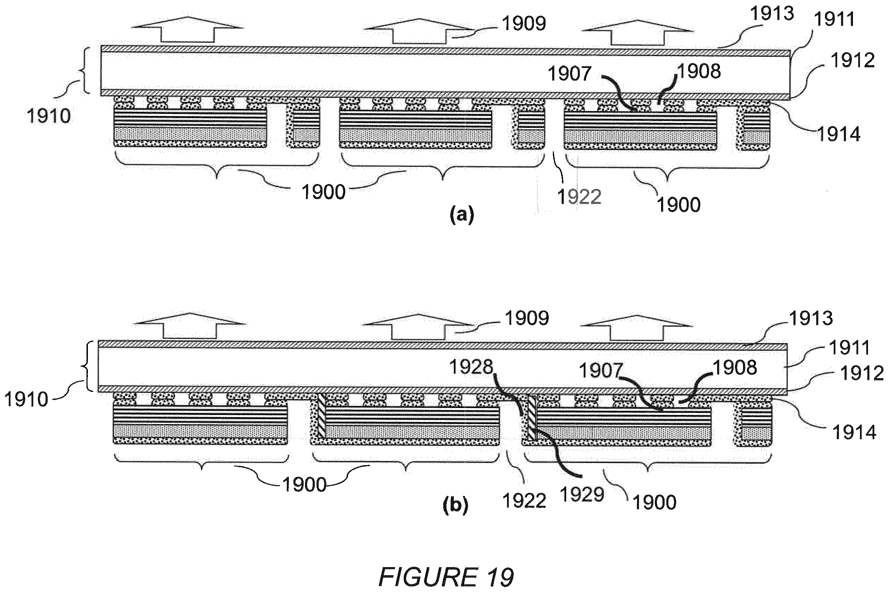

In an alternative embodiment, larger size array modules are produced by configuring a plurality of array chips electrically connected in predetermined arrangement for different applications, as shown in Figures 19a and 19b. The plurality of array chips may be connected in a wafer level processing, as well as by assembling them on a common transparent carrier substrate. Although Figures 19a and 19b show a plurality of array chips, for clarity of representation, only one set of elements are labeled. Furthermore, identical elements or elements with similar functionalities in Figures 19a and 19b are labeled with same reference numerals unless stated otherwise. To keep the description short, identical elements in Figures 19a and 19b will be described together and only the differences between the two embodiments will be described separately.

More specifically, the array modules shown in Figures 19a and 19b include a plurality of surface mountable array chips 1900 substantially similar to the ones described in reference with Figures 13a, 13b, 13c and 13d. The surface mountable array chips will not be described in detail. The array chips may be electrically connected at the wafer level (or assembled) in a predetermined pattern on a common transparent carrier substrate 1910. Referring simultaneously to Figures 19 and 15, the carrier substrate is substantially similar to the section 1510 described with reference to Figure 15a, for example. In particular, the section 1910 comprises a transparent carrier substrate with top and bottom surfaces coated with antireflection layers 1912 and 1913, respectively.

A metallization layer 1914 is disposed on the top antireflection layer 1912. Windows are selectively created on the metallization layer to match corresponding emission windows 1908 (only one labeled) of the array chip. The remaining parts of the metallization 1914 layer surrounding the windows are used as bonding pads that match corresponding bonding pads 1907 (only one labeled) on the array chip. Several options to create windows and the metal pads by selective etching or by selective deposition are well known in the art, and would work equally well.

The carrier substrate is designed to accommodate a plurality of array chips separated by a gap 1922 (only one labeled) or a trench between adjacent array chips. The array chips may be electrically isolated from one another, electrically connected in parallel, or may be connected in series using a metal track 1928 over an isolating material 1929 for example, such that the bottom terminal of one array chip is connected in series with the top terminal of an adjacent array chip. The metallization pattern 1914 on the substrate may be designed to connect the array chips in a desired configuration. The isolating material 1929 may include but is not limited to, a photoresist, or a polymer for example, as is well known in the art.

Although the exemplary array module including a plurality of array chips is described in reference with a top emission type surface mountable array chip, the principles may be extended to bottom emission chips as well. Furthermore, the carrier substrate 1910 in this example is shown as a clear window, it may include other optical elements shown in Figure 18, such as a diffuser window, microlens array etc. Those skilled in the art will be able to appreciate that every aspect of the construction of array module including optical elements may be implemented in a modular fashion, thereby providing significant flexibility in design choices, and easy expansion to high power modules.

One important aspect of this invention is that an array module as shown in Figure 19 may entirely be constructed in a wafer level processing in a modular fashion. In one preferred embodiment of the invention, a plurality of array modules each including one or more array chips connected in a desired configuration, are first fabricated monolithically on a single wafer. Referring now to Figure 13 and Figure 19 simultaneously, a wafer is first processed to construct at least one reflector and the light emitting region on the entire wafer in an epitaxial growth step. The second reflector may be constructed in one or two steps as per the design requirement for example, if the second reflector is a single type of reflector (Figure 13) or a hybrid reflector. Array chips and interconnection between the array chips in a desired configuration namely, series or parallel connected array chips, are defined using selective metallization or selective etching, to monolithically construct the emission side contact in this particular example. The processed wafer may then be bonded to a transparent carrier substrate that is prepared separately.

The carrier substrate is processed separately to construct the windows, trenches and bonding pads that would substantially match corresponding elements on the array module wafer. The carrier substrate is bonded to the entire array module wafer using metal-metal bonding, capillary bonding, solder pad bonding or any other bonding method using heat, pressure or a combination thereof, that are well known in the art. In another variation, the array module wafer bonded to the carrier substrate, may further be processed for example, the substrate may be thinned significantly, or removed completely to prevent absorption of emitted light in the substrate of for providing better thermal management. The non-emission side contact may be made before or after the bonding of the array module with the carrier substrate. It may be appreciated that other than the exemplary sequence described here, many processing options that are well known in the art are also available to practice the invention and are not precluded within the broad framework of this invention.

Advantageously, the principles described here offer a multitude of design choices and expansion options for constructing or expanding a VCSEL array illuminator in a modular fashion. For example, in one variant embodiment, the VCSEL devices in an array chip may be arranged in any arbitrary array pattern instead of a regular array pattern to conform to any shape and/or size of the area to be illuminated. The array chips may be electrically connected in many different ways (series or parallel) to expand the size of the array module, or to construct array modules to illuminate any arbitrary shaped area, for example. Furthermore, optional optical components including but not limited to, beam shaping components, such as diffuser, microlens or microlens arrays may be further bonded to the carrier substrate as has been described in reference with Figure 18. The bonded wafers may be diced to produce smaller array modules for applications as individual modules or may be assembled on a common thermal substrate or a heat dissipation device to produce larger size array modules. The array modules described in reference with Figures 15, 16, 17 and 18 are particularly suited for a high-throughput manufacturing environment, thereby substantially reducing the cost of high quality illuminator modules.

As an alternative, array chips of different size and shapes may be first separated from a processed wafer and each array chip may be tiled together to construct an array module of a predetermined shape and/or size and connected in a prescribed or required electrical configuration for obtaining a desired output power and shape for illuminating a surface/object, depending upon the application. A common transparent carrier substrate is then bonded to the entire tiled arrangement of array chips in one step. One advantage of this approach is to be able to construct a module from pre-fabricated array chips. Those skilled in the art will be able to appreciate a wide range of design choices including those for power and thermal management, are available within the broad framework of this invention.

### VCSEL Illuminator Module

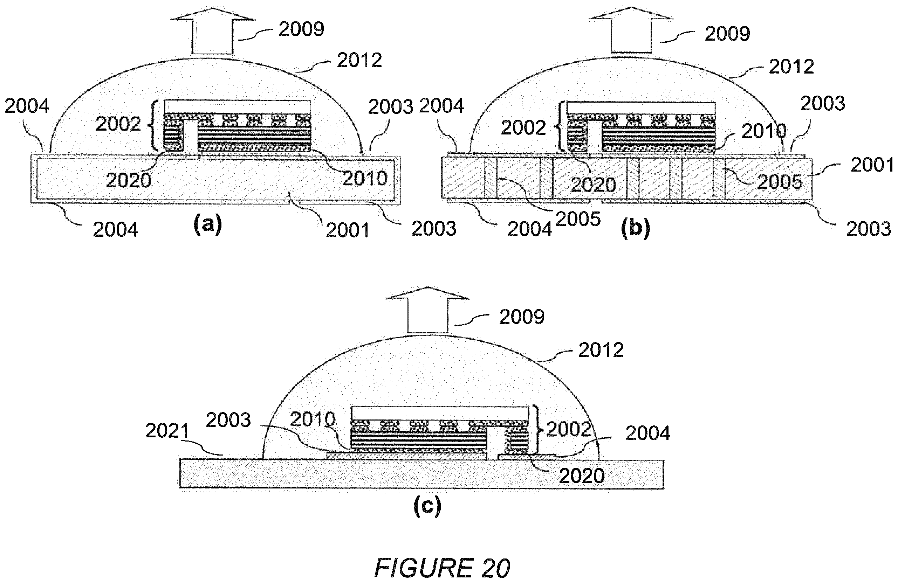

Surface mountable VCSEL array chips or array modules as described in the previous sections, may be assembled in many different ways to construct an illuminator module. An exemplary illuminator module is shown in Figure 20a and different embodiments of an exemplary illuminator module are shown in Figures 20b and 20c. Elements that are substantially similar or have substantially similar functionality, are labeled using same reference numerals. For convenience, a general description is presented with reference to the example shown in Figure 20a; however, it is equally pertinent to embodiments shown in Figures 20b and 20c as well. In particular, the illuminator module shown in Figure 20a comprises an array module
2002 having one or more surface mountable array chips described earlier with reference to Figures 13, 15, 16, 17 and 18. That description will not be repeated.

The surface mountable array module may be bonded to a thermal submount 2001 for efficient heat dissipation. Different types of thermal submount described in United States Patent Application No. 13,337,098, Seurin etal., filed on December 24, 2011, will be equally effective for this purpose. The array module terminals 2010 and 2020 are bonded to the wrap around contact pads 2003 and 2004, respectively, located on the top and bottom surfaces of the thermal submount 2001. In an alternative embodiment shown in Figure 20b, the contact pads 2003 and 2004 on the thermal submount top surface are electrically connected to corresponding bottom contact pads using via holes 2005 (only a few labeled) located between the top and bottom surfaces of the thermal submount 2001. It should be clear to one skilled in the art that various submount configurations as described in Figures 1-6 can be used. The array modules may bonded using solder, heat, pressure or a combination thereof, which are well known to be more reliable and cost effective as compared to wire or ribbon bonded contacts described in United States Patent Application No. 13,337,098, Seurin et al., filed December 24, 2011.

The array module 2002 may be further encapsulated using a transparent polymer for example, to protect the emission surface. While polymer encapsulation is well known in the art, in the illuminator modules shown in Figures 20a and 20b, the transparent polymer is selected and applied so as to provide additional optical functions. In the exemplary embodiment shown in Figure 20, the encapsulation 2012 is designed to function as a lens. The lens radius and the height above the array module are predetermined, such that the light 2009 is emitted from the encapsulated illuminator module in a pattern selected to suit a particular application. For example, to obtain a uniform illumination pattern at a relatively large distance away from the illuminator module, the polymer encapsulation lens is designed to function as a collimator, and so forth.

In a variant embodiment shown in Figure 20c, an array module 2002 is surface mounted to electrical pads 2003 and 2004 on a Printed Circuit Board (PCB) 2021 at the respective terminals 2010 and 2020. The PCB 2021 includes electronic circuits (not visible in this view) to provide drive current and/or control functions to the array module. In this embodiment, the transparent polymer encapsulation is provided on the PCB surface to protect the array module and the associated electronic circuits. The embodiments shown in Figure 20 are particularly suitable as low power stand-alone illuminators for illuminating small surface area. Small low power portable illuminator module that does not require additional heat dissipation arrangement, may be designed to operate using batteries for example.

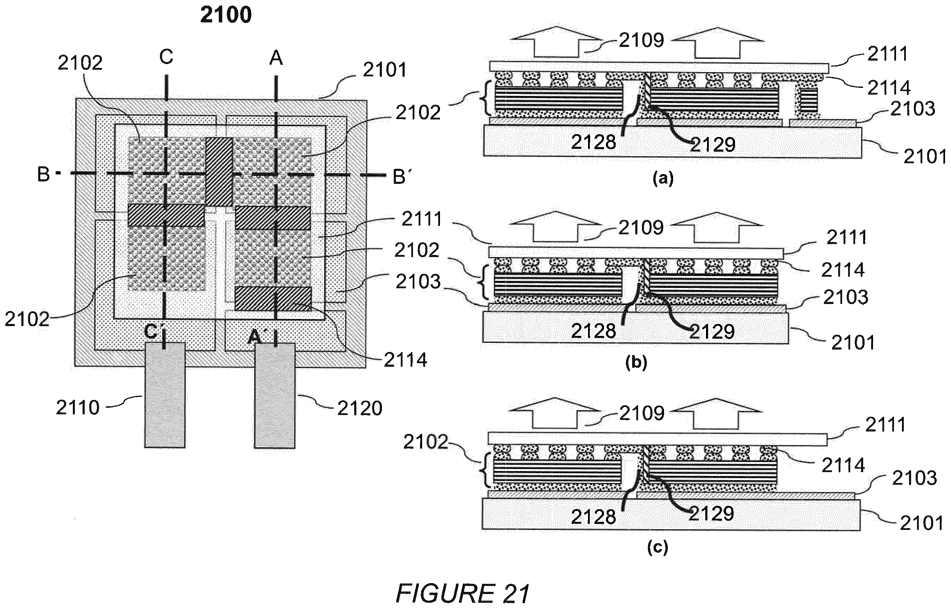

For obtaining higher-power illuminator or to illuminate a large surface area, array modules are constructed by tiling multiple arrays on a common transparent carrier substrate, similar to the one described with reference to Figure 19. Such an array module may be constructed either by tiling the required number of array chips monolithically in a wafer level processing followed by bonding the monolithically integrated array module to the carrier substrate, or by tiling individual modules on a common carrier substrate. One example of an array module using four array chips is shown in Figure 21. Figure 21 shows a schematic planar view 2100 on the left side of the page, and three different cross section views 21a, 21b and 21c, on the right hand side of the page, projected respectively, at lines AA', BB', and CC' shown in the planar view (each rotated at 90° from the previous cross section view). Elements that are substantially similar or provide substantially similar functions are labeled using same reference numeral for ease of description and to avoid repetition.

More specifically, the illuminator module shown in Figure 21 comprises four array chips 2102, arranged monolithically in a 2x2 array pattern on a common substrate (not shown). In this exemplary module, light is emitted in a square area which is particularly suitable for lighting a screen, readout, or a back plane, for example. On the emission side, the monolithic 2x2 array is bonded to the carrier substrate 2111. The carrier substrate includes a metallization layer having windows created on the metallization layer to match with the windows on the array chip. For bonding to the array chip, the carrier substrate is flipped to match metal contacts on the substrate to the metal pads on the array chips. In this particular example the four array chips are electrically connected in series using connector bridges 2114 constructed on the carrier substrate 2111 and additional connectors 2128 supported on an insulator layer 2129 (not visible in the planar view) in the gap between adjacent array chips.

Individual contact pads 2103 are constructed for each array chip of the monolithic 2x2 array on the non-emission side. The contact pads may be arranged so that the array chips are connected in series. The contact pads 2103 are used to surface bond the 2x2 array on corresponding pads located on a common base 2101. The two terminals of the array module are accessed through the two metal strips 2110 and 2120, respectively (not visible in the cross section views). The common base may include but is not limited to, a thermal submount, a PCB including one or more electronic circuit(s) or a combination thereof. Additional heat dissipation devices may be used for air or liquid cooling of the array module. As mentioned earlier, any bonding method including but not limited to, solder, heat bonding, pressure bonding, capillary bonding or a combination thereof, may be used for different bonding steps.

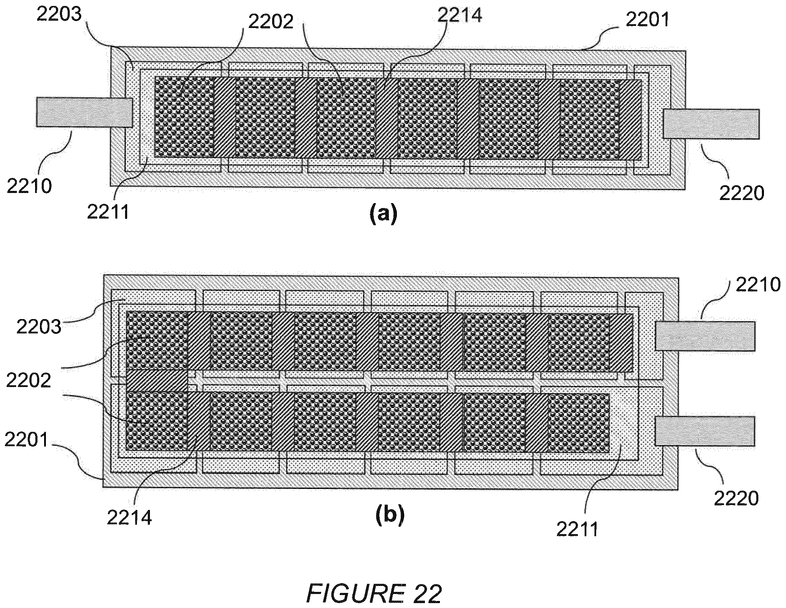

One advantage of modularly constructing the array module according to this invention is that the array chips can be of any shape and/or can be tiled to suit any regular or arbitrary geometric shape conforming to the area or object to be illuminated. Another advantage of tiling of array chips results in obtaining higher output powers, or to cover larger illumination area in a modular fashion. Two exemplary arrangements of array modules configured in a 1x6 linear array and a 2x6 two-dimensional array, respectively, using square array chips to emit light in a rectangular area are shown in Figure 22a and 22b. A particular application of this configuration is in side pumping of a bar of a solid state gain medium, for example.

More specifically, square array chips 2202 are configured in a 1x6 linear array and a 2x6 two-dimensional array, respectively, using standard processing steps described in reference with Figure 21. In Figures 22a and 22b elements that are substantially similar or provide substantially similar functionality, are labeled with same reference numeral for ease of description. A transparent carrier substrate 2211 including a metallization layer, having windows to match with the windows on the array chip, is bonded on the emission side of the array chips using metal contact pads 2214. The bonding may be achieved either by soldering heating, applying pressure, by capillary action, or a combination of techniques that are well known in the art. Advantageously, a large number of modules may be constructed monolithically on a single wafer, bonded to a common carrier substrate, and may be separated if needed, by dicing the finished modules.

The array chips include individual contact pads 2203 for surface mounting to a common base 2201. The common base may include but is not limited to, a thermal submount, a PCB including electronic circuits, etc. The array chips are electrically connected in series as has been described earlier in reference with Figure 21 so as to operate them together using a drive current applied between the electrical connectors 2210 and 2220 connected respectively to two terminals of the array module. The two terminals of the array module are accessed through the two metal strips 2210 and 2220, respectively, for example to provide electrical connection to apply a drive current. The electrical connectors may be located at opposing ends of the module (Figure 22a) or they may be located on the same side of the module (Figure 22b).

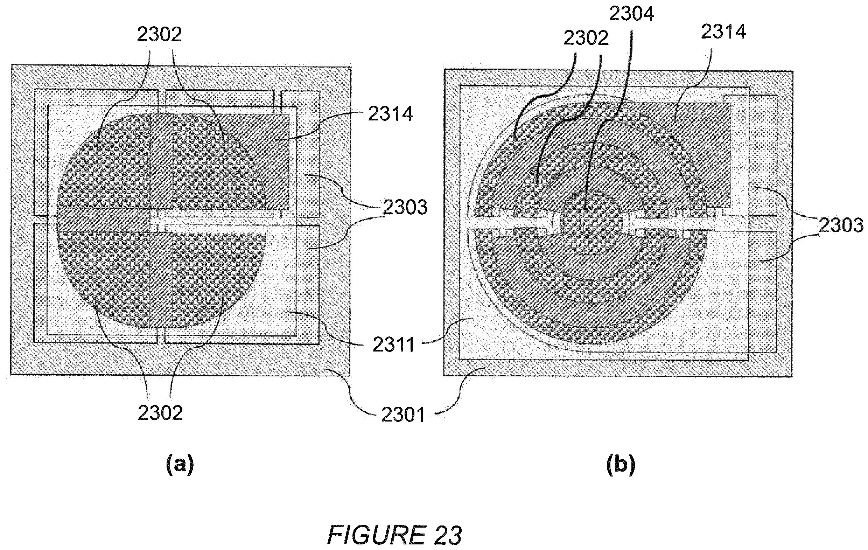

In another embodiment of the invention, array chips are configured in a circular pattern as shown in Figures 23a and 23b. In one arrangement shown in Figure 23a, an array module to emit light in a circular area is configured using four quarter circle array chips 2302 that are monolithically constructed on a common substrate. A transparent carrier substrate including electrical contact pads 2314 (only one labeled for clarity) is bonded to the array chips such that the array chips are electrically connected in a desired configuration, for example in series for this particular embodiment. The entire module is diced and bonded on the pads 2303.

In an alternative arrangement shown in Figure 23b, an array module to emit light in a circular area is configured using a central circular array chip 2304 and concentric arranged in half rings (2302) that are connected in series on a carrier substrate 2311. The array chips are constructed monolithically and bonded to the carrier substrate 2311 that includes emission windows and metallization pads 2314 with appropriate geometry, to match the geometrical arrangement of the array chips. The array chips bonded to the carrier substrate is diced and assembled on the bonding pads 2303. The emission area is circular in the embodiments shown in Figures 23a and 23b, and is particularly suitable for end-pumping a solid state gain medium, for example.

It should be noted that the embodiments shown in Figures 21, 22 and 23 are described to have the array chips connected in series. This configuration is particularly suitable for low electrical current operation of the array module, yet delivering high optical output power. In general, the array modules may be first constructed on a common substrate with appropriate electrical connections between each array chip, either in series or in parallel, according to the output optical power requirement. The combined array module may then be bonded to a single transparent carrier substrate all at once. Alternatively, and in particular for array modules connected in parallel, individual array modules may be connected separately one by one or in smaller groups, to the carrier substrate. These different choices have been described earlier with reference to Figure 19.

It should also be noted that the carrier substrate shown in Figures 21, 22 and 23 functions as a simple transparent optical window. It need not be so in all applications. As described in reference with Figure 19a -19c, the top surface of the transparent carrier substrate may further include additional optical elements such as a diffuser, a single lens, a microlens array, etc., to provide beam shaping. The optical elements may be arranged on the entire surface of the transparent window or may be placed in other arrangements according to the beam shaping requirements pertaining to each application. While only a few exemplary alternatives are shown and described, other variations may be apparent to those skilled in the art and may be practiced within the framework of this invention.

### VCSEL Array Illuminator Module

The surface mountable VCSEL array modules described in the previous section are particularly suitable for configuring illuminator modules. The array chips or array modules may be mounted on a large area high thermal conductivity base for example a thermal submount using metal-metal heat and/or pressure bonding methods well known in the art. The high thermal conductivity base comprises of materials that include but are not limited to, metal such as copper, aluminum, etc. or ceramics such as beryllium oxide (BeO), aluminum nitride (AIN), aluminum oxide (Al₂O₃), etc.

The surface mounted array modules in thermal contact with the large area high thermal conductivity base provide large surface for rapid heat dissipation that may be effected through air cooling, particularly for small illuminator modules, or by circulating liquid coolants in one or more microchannel cooler for rapid heat transfer. Different types of cooling arrangements that may be readily adapted for constructing illuminator module using the surface mountable array modules according to this invention, are described in United States Patent Application No. 13/369,581, van Leeuwen et al., filed February 09, 2012.

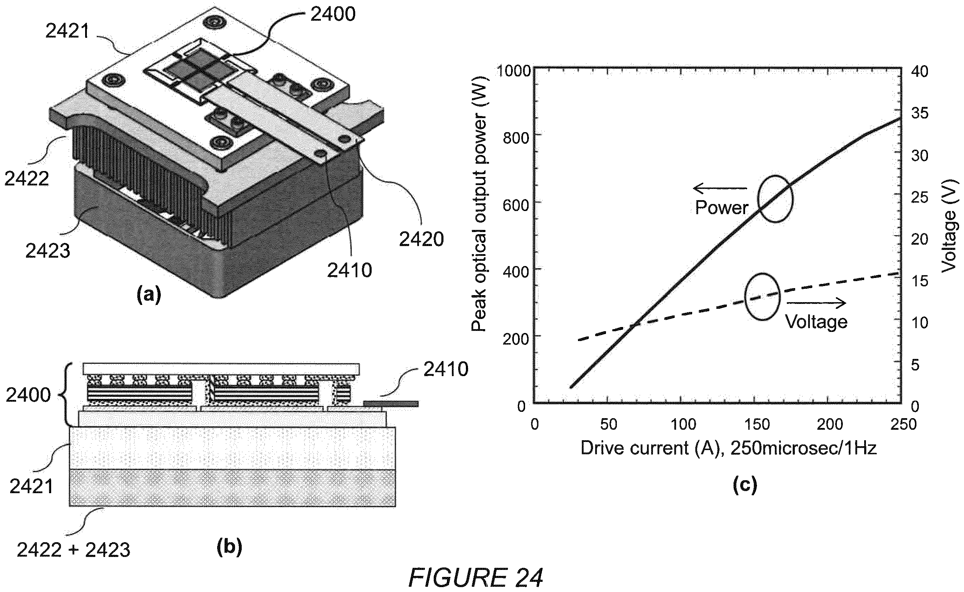

In the following sections, several exemplary embodiments of illuminator modules will be described that utilize array chips or array modules configured according to the principles described in the previous sections. An array module having four VCSEL array chips described earlier with reference to Figure 21 is assembled to construct an illuminator module constructed according to this invention shown in Figure 24. More specifically, Figure 24a shows a VCSEL illuminator in isometric view and a cross section view of the illuminator is shown in Figure 24b. The elements that are substantially similar are labeled using same reference numerals. The illuminator module shown in Figure 24 includes an array module 2400 that is substantially similar to the array module 2100 described with reference to Figure 21. That description will not be repeated. The array module includes electrical leads 2410 and 2420, connected to the two terminals of the array module, respectively.

In this embodiment of the illuminator module, the surface mountable array module 2400 without any wire or ribbon bonding is directly mounted on a copper heat sink 2421. The heat sink further includes a set of cooling fins 2422 (not visible in Figure 24b) to facilitate rapid heat transfer by air circulation from a fan 2423. One advantage of direct surface mounting described in this example is to avoid device failure due to snapping of wire or ribbon bonding.

Figure 24c shows performance characteristics of an illuminator module similar to the one shown in Figure 24a. More specifically, device voltage (on the right hand side Y-axis) is plotted (dashed line plot) as a function of applied drive current (x-axis) and the output optical power (on the left hand side Y-axis) is plotted (solid line plot) as a function of applied drive current in the graph in Figure 24c. The data shown in this graph is obtained for a quasi continuous wave (QCW) operation. The exemplary illuminator module produces about 800 W of optical power by applying 250A current at a 200 microsec/1Hz duty cycle. It is noted that the voltage and slope efficiency are characteristic of the entire array module including the four arrays connected in series. One advantage of QCW operation is that the device life is extended significantly. The operating conditions described here is exemplary and it should be noted that the illuminator module may also be operated in pulsed or CW mode operation, albeit with different performance.

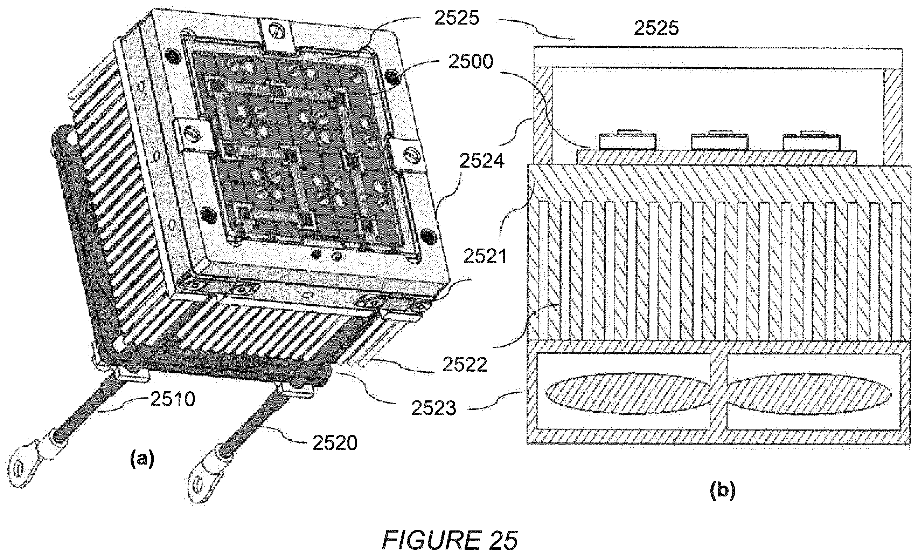

An exemplary illuminator module for providing high optical output power is shown in Figure 25. In particular, Figures 25a and 25b respectively, show an isometric view and a cross section view of one embodiment of an illuminator module configured for high output optical power. The elements labeled with the same reference numerals in Figures 25a and 25b are identical or provide substantially similar function. More specifically, in Figure 25a an array module 2500 is constructed using nine square array chips connected in series. The array chips are connected to a current source driver via a pair of high current capacity electrical leads 2510 and 2520. The electrical leads are not shown in the cross section view in Figure 25b.

In this particular illuminator module, a 3x3 array pattern is configured using nine array chips constructed monolithically on a common substrate and electrically connected in a desired configuration (in series in this particular embodiment, for example) using connectors provided on a transparent carrier substrate as has been described earlier in reference with Figures 21, 22 and 23. Individual modules may be diced and bonded to a common substrate. The common substrate (not shown here separately) may include but is not limited to, a thermal submount, a ceramic substrate with metal contacts, a PCB, etc. A heat dissipation device 2521 including a plurality of cooling fins 2522 is provided for air cooling the array module with a fan 2523. As an option, a protective housing 2524 including a transparent window 2525 may additionally be provided for protecting the optical module. While this particular embodiment is shown only with a protective window 2525, additional optical elements as described in reference with Figure 18 and 19 may be further provided for additional beam shaping requirements.

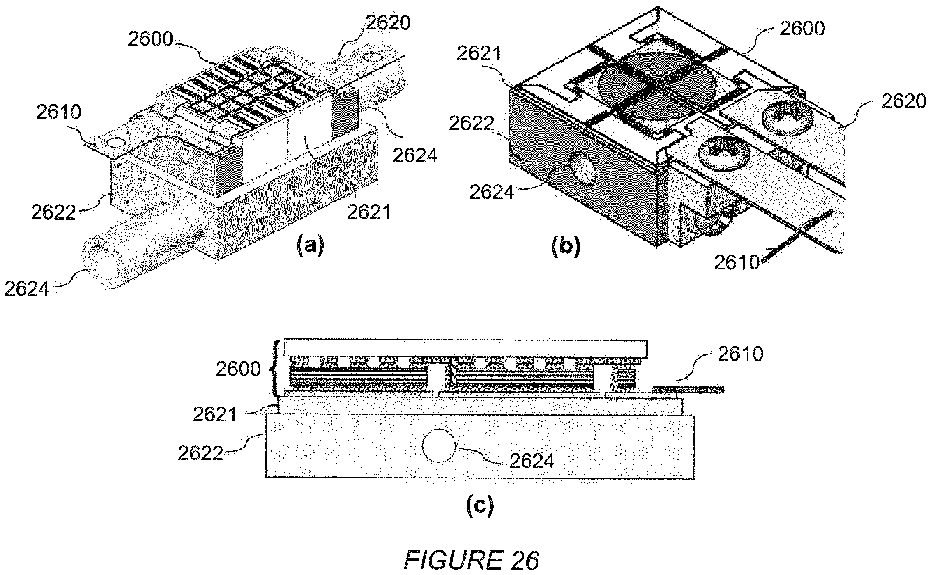

For array modules configured for higher output power, other cooling methods are preferable. In one embodiment of the invention liquid cooled micro channel coolers may be used to provide rapid heat dissipation. Examples of liquid cooled illuminator modules are shown in Figure 26. In Figure 26a, the module 2600 comprising array chips arranged in a 2x6 pattern having electrical contacts 2610 and 2620 on two opposite ends is shown. The array module is substantially similar to the one described with reference to Figure 22b and that description will not be repeated. The finished array module is assembled on a thermal including a pair of micro-channel coolers 2621 that are attached to a manifold 2622 including inlet and outlet ports 2624 to circulate a liquid coolant.

The embodiment shown in Figure 26b is similar to the one shown in Figure 26a except for the array module 2600. In that example, a circular array module substantially similar to the one shown in Figure 23a is assembled on a submount 2621. The two electrical contacts for the array 2610 and 2620 are located side by side. The submount is substantially similar to the one shown in Figure 24a as well. The submount in this example is bonded to a liquid cooled heat sink 2621 having an inlet and outlet port 2624 (only one visible in this view). Details of the illuminator modules shown in Figures 26b are more clearly visible in the cross section view shown in Figure 26c. The array module collectively labeled as 2600 is bonded to a submount 2621. In this view only one electrical contact 2610 to the array module is visible. The entire assembly is then bonded to a heat sink 2622 having an arrangement for circulating a liquid coolant through a port 2624. While the embodiment is described using a simple liquid cooled heat sink, illuminators having larger array modules may be assemble with other types of liquid cooled heat sink that are well known in the art.

And while the packaging of the high optical power illuminator module shown in Figure 25 is different from a low optical power illuminator module described earlier with reference to Figures 24 and 26, where the transparent window is bonded to the array module itself, the basic principles of constructing the illuminator modules are still the same. In variant embodiments, the window 2625 or equivalent (2111, 2211, 2311, respectively in Figs. 21,22 and 23) in the embodiments using smaller array modules may include but is not limited to, a diffuser surface, additional optical elements such as a lens or an array of microlenses, etc. that were described earlier with reference to Figure 18. The diffuser surface may be designed to provide optical functions to suit particular application for example, random scattering, or providing optical diffraction or holographic surface for increasing divergence, etc. just to name a few.

### System Level Integration of VCSEL Array Module

One important aspect of the surface mountable VCSEL array chips and array modules is that they may be easily integrated with electronic circuits on a common platform to configure stand alone illuminator modules or complete systems and devices in applications including but not limited to, continuous wave (CW) or quasi continuous wave (QCW) illumination, pulsed illumination, LIDAR applications, imaging, 3D gesture recognition, medical applications such as hair removal, wrinkle removal, photodynamic therapy and fat removal, signal flare, automobile ignition, just to name a few. The electronic circuits may include a simple current driver circuit to operate an array module or more complex control and processing circuits for application in complete systems.

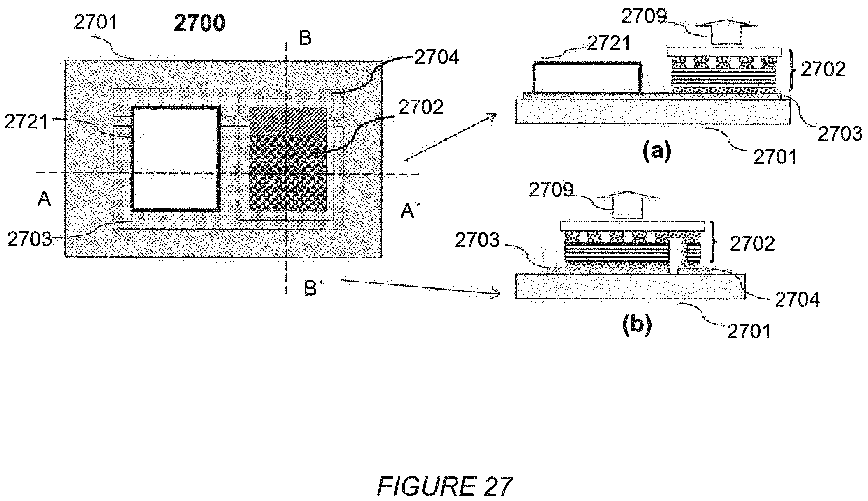

An exemplary embodiment to explain the principles of a simple stand-alone illuminator module is shown in Figure 27. More specifically, a schematic view 2700 depicts a planar view of the illuminator module including a surface mountable array module 2702 and an electronic circuit 2721, respectively. The surface mountable array module 2702 may be similar to the one described in reference with Figures 15, 16, 17, 18 and 19, or may be a surface mountable array chip, similar to the ones described in reference with Figures 13a-13d. The electronic circuit in this particular example is a current driver to power the array module. The electronic circuit is electrically connected to the array module using metal bonding pads (or traces) 2703 and 2704, respectively, located on the same side of a high-speed PCB 2701. One advantage of integrating the array module with the current driver is to provide lower inductance and capacitance for the connecting leads resulting in very fast rise and fall time operation of the illuminator module.

Figures 27a and 27b show cross section views of 2700 along two different projection lines AA' and BB', respectively, selected at right angles to each other. For clarity, same reference numerals are used to label identical elements. In Figures 27a and 27b, the array module is collectively shown with the bracket 2702. The array module and the electronic circuit may be surface mounted on the PCB at the respective metal pads 2703 and 2704 located on the same surface of the PCB, using heat and/or pressure bonding methods well known in the art. Notably, no wire or ribbon bonding of the contacts from the top surface of the array module or the electronic circuit is necessary, thereby reducing the risk of electrical contact failure, and in particular for high output power illuminators where rise in temperature at the contact points can be quite high.

The array module in this exemplary embodiment is shown with a single square array chip; however, other configurations having multiple array chips (shown in Figures 19 and 21) may also be used for obtaining higher optical power illuminator modules. The choice of the common platform may be decided by the size of the illuminator and requirement for heat removal. For example, the PCB may be mounted on a heat sink comprising a high thermal conductivity material. For a high output power device, the common platform may be a PCB constructed form a high thermal conductivity material for rapid heat dissipation.

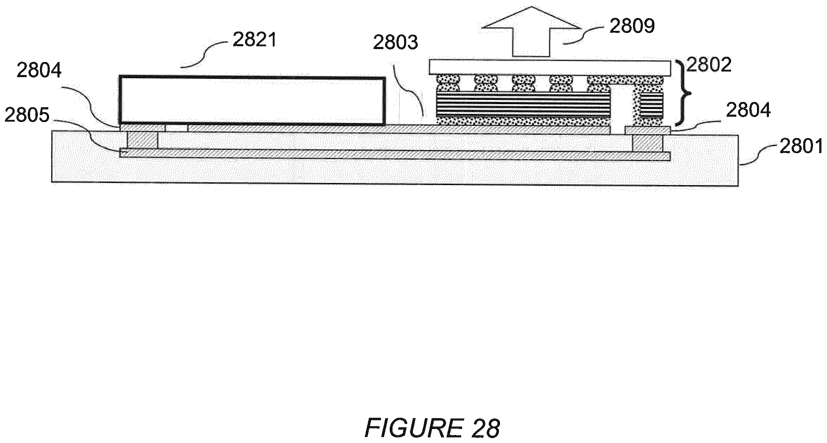

For higher degree of integration, for example where multiple electronic circuits are to be integrated with one or more array modules, multi-level PCB may be used. One such example is shown in Figure 28. For clarity, the embodiment is shown to include an array module and a current driver circuit similar to the example shown in Figure 27. However, same principles may be extended to a higher level of integration. In particular, an array module 2802 shown collectively with a bracket, and a current driver circuit 2821 are surface mounted on a PCB 2801 having multi-level tracks. The array module is connected to the electronic circuit using a common bonding pad 2803 located on one level of the PCB, whereas the second bonding pad 2804 is connected using a track 2805 located at a lower level, respectively.

This aspect is particularly useful in applications where multiple electronic circuits have to be connected with one or more array modules. Additional advantage of this configuration is that heat dissipation of the module can be more efficient. For example, the tracks carrying higher current may be located at a level that is closer to the heat sink, whereas the tracks carrying low current signals for example, signals providing sensor or control functions may be located on a surface further away from the heat sink. Those skilled in the art will be able to appreciate the flexibility in design options provided within the broad framework of this invention is enormous, especially for high optical power illuminator modules. Design choices in this invention in constructing optical illuminators conforming to different shapes and sizes of areas to be illuminated to suit a wide range of applications. A few examples of high level integration using optical modules described earlier will now be presented.

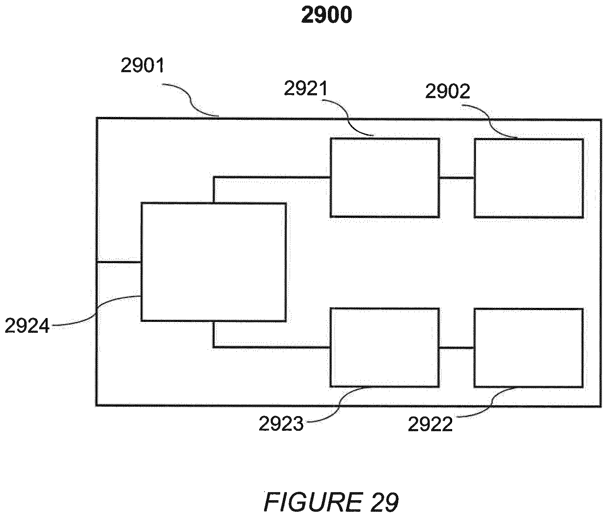

One example of a schematic representation of a high level integration is shown in Figure 29. More specifically, one or more array modules with a plurality of electronic circuits to provide different functionalities may be configured on a PCB having multiple conductor layers. A planar view 2900 of an integrated illuminator system shown in Figure 29, comprises an array module 2902 integrated with a current driver circuit 2921 on a common PCB 2901, similar to the one described with reference to Figures 27 and 28. In addition, an optical sensor or a camera module 2922 along with its driver circuit 2923 and a microprocessor device 2924 is integrated with the array module to assemble a compact motion or gesture recognition apparatus.

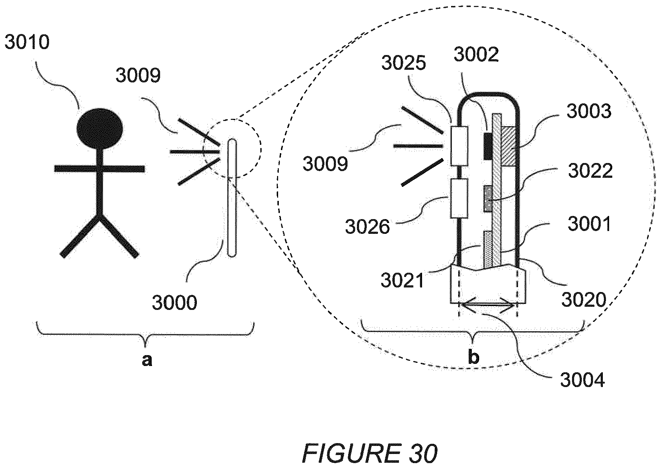

In one embodiment of the invention a motion or gesture recognition apparatus in a relatively thin form factor is shown in Figure 30. This embodiment is particularly useful for applications in consumer devices that include but are not limited to, cell phones, tablet computers, computer monitors, digital watches, portable digital media players, gaming consoles etc. to name a few. The apparatus and its expanded view are shown in Figures 30a and 30b, respectively. The apparatus is enclosed in an enclosure 3000 that is 15x20 cm² in area and is typically ≤ 0.5 inches thick as shown by the double headed arrow 3004 in Figure 30b. The light emitted from the apparatus 3009 illuminates a subject 3010. For example, in a gesture recognition application the object that is illuminated is a face of a person. However, the application is not restricted to facial gesture and may be applied to detect any other gesture or motion.

The principle of operation of the apparatus may be understood with reference to the expanded view of the apparatus shown in Figure 30b. The apparatus 3000 comprises an illuminator module 3002 integrated with an imaging sensor or a camera device 3022 and an electronic circuit(s) 3021 surface mounted on a common PCB 3001. The PCB may optionally be mounted on a thermally conductive mount 3003. The PCB with all the components is enclosed in a housing 3020 including two windows 3025 and 3026 aligned respectively with the illuminator module (emitting window) and the sensor or camera device (receiving window), respectively.

The VCSELs devices in illuminator module may be arranged in a pre-determined pattern which defines a grid of emitted light as will be described shortly. The emitted light 3009 from the illuminator module is magnified using optical elements and projected on to the subject in a known pattern. The light reflected from the subject is directed using collection optics, through the transparent window 3026 to the imaging sensor or the camera device. The reflected light is detected by the imaging sensor device and analyzed to determine subject position and any changes due to movement.

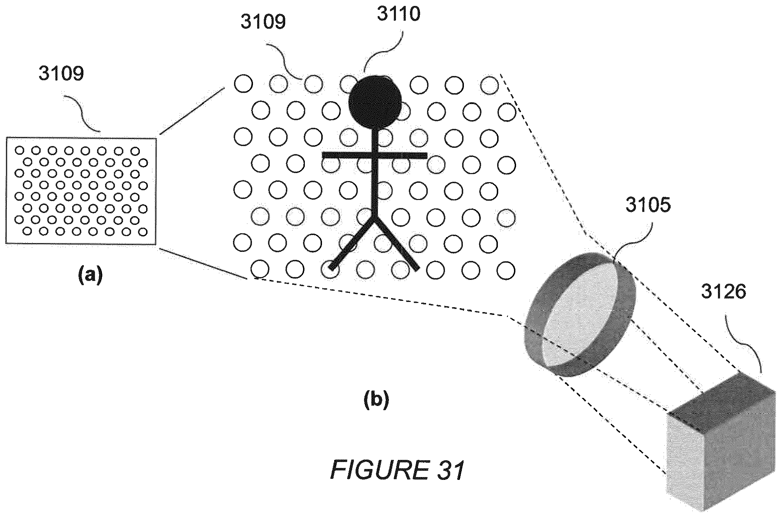

A more detail drawing of the emitted light from the illuminator module is shown in Figure 31. More specifically, Figure 31a shows a detail grid pattern of emitted light 3109 from the illuminator module, and Figure 31b shows a schematic view of the detection system including receiving optics 3105 and the receiving window 3126, respectively. The receiving optics may be a simple focusing lens or may include other optical elements that may be separate or integrated with the receiving window, the imaging sensor or the camera device behind it. Referring now simultaneously to Figs. 30 and 31, in the absence of a subject 3110 within the illuminated area 3109, the imaging sensor would image the grid pattern 3109 of the illumination area.

A reference image of each element of the grid pattern of the illumination area is thus recorded and stored in a processor (not shown) included in the electronic circuit(s) of the apparatus. In the presence of the subject, the imaging sensor would register the changes in the reflected light from the subject, thereby imaging the subject. Any changes in the reflected light due to movement will be recorded and compared with the reference image to detect motion or gestures. The recording and image processing may be performed real time or using stored data in the processor. It can be easily appreciated that the compact form factor and portability of the apparatus described here is particularly advantageous in field applications.

## Claims

1. An optical illuminator module comprising:
a) a plurality of Vertical Cavity Surface Emitting Lasers (VCSELs) (202, 302) forming a two-dimensional array (111, 209, 309, 409, 509, 609, 709) constructed on a common substrate (97, 101, 112, 201, 301, 701, 1301, 1401, 5101, 1601, 1701) having a bottom surface comprising a bottom contact forming a first terminal of the two-dimensional array and a top surface comprising a top contact forming a second terminal of the two-dimensional array, the plurality of VCSELs generating an optical output beam (114, 308) that propagates from the top surface of the common substrate (97, 101, 112, 201, 301, 701, 1301, 1401, 5101, 1601, 1701); and
b) a submount (113, 203, 303, 403, 703, 803, 903, 1103, 2001) having a first surface comprising a plurality of bonding pads (204, 205, 304, 305, 404, 504, 505, 604, 605, 704, 1104, 1105, 2003, 2004) electrically isolated from each other and a second surface that is opposite the first surface, the second surface comprising a plurality of bonding pads (214, 215, 314, 315, 415, 418, 514, 515, 518, 614, 630, 1115, 2003, 2004) electrically isolated from each other, wherein a first respective one of the plurality of bonding pads (204, 205, 304, 305, 404, 504, 505, 604, 605, 704, 1104, 1105, 2003, 2004) on the first surface is electrically connected to a first respective one of the plurality of bonding pads (214, 215, 314, 315, 415, 418, 514, 515, 518, 614, 630, 1115, 2003, 2004) on the second surface with a first plurality of via holes (311, 411, 511, 611, 1111, 2005);
wherein the bottom contact of the common substrate (97, 101, 112, 201, 301, 701, 1301, 1401, 5101, 1601, 1701) is electrically connected to the first respective one of the plurality of bonding pads (204, 205, 304, 305, 404, 504, 505, 604, 605, 704, 1104, 1105, 2003, 2004) on the first surface of the submount (113, 203, 303, 403, 703, 803, 903, 1103, 2001) such that the two-dimensional array is in thermal contact with the submount (113, 203, 303, 403, 703, 803, 903, 1103, 2001), and
the top contact of the common substrate (97, 101, 112, 201, 301, 701, 1301, 1401, 5101, 1601, 1701) is electrically connected to a second respective one of the plurality of bonding pads (204, 205, 304, 305, 404, 504, 505, 604, 605, 704, 1104, 1105, 2003, 2004) on the first surface of the submount,
**characterised in that** the second respective one of the plurality of bonding pads on the first surface is electrically connected to a second one of the plurality of bonding pads (214, 215, 314, 315, 415, 418, 514, 515, 518, 614, 630, 1115, 2003, 2004) on the second surface with a second plurality of via holes (311, 411, 511, 611, 1111, 2005).

2. The optical illuminator module of claim 1, wherein the first and second plurality of via holes (311, 411, 511, 611, 1111, 2005) are filled with an electrically and thermally conductive material.

3. The optical illuminator module of claim 2 wherein the electrically and thermally conductive material comprises at least one of copper, silver and gold.

4. The optical illuminator module of claim 1, 2 or 3, wherein the top contact is electrically connected to the second one of the plurality of bonding pads (204, 205, 304, 305, 404, 504, 505, 604, 605, 704, 1104, 1105, 2003, 2004) on the first surface of the submount (113, 203, 303, 403, 703, 803, 903, 1103, 2001) with a plurality of wire bonds (206, 210, 306, 406, 410, 506, 510, 606, 619, 706, 806, 906, 1106).

5. The optical illuminator module of claim 1, 2 or 3, wherein the top contact is electrically connected to the second one of the plurality of bonding pads (204, 205, 304, 305, 404, 504, 505, 604, 605, 704, 1104, 1105, 2003, 2004) on the first surface of the submount (113, 203, 303, 403, 703, 803, 903, 1103, 2001) with a wide bonding ribbon (206, 210, 306, 806, 1106).

6. The optical illuminator module of any preceding claim, wherein the second one of the plurality of bonding pads (204, 205, 304, 305, 404, 504, 505, 604, 605, 704, 1104, 1105, 2003, 2004) on the first surface of the submount (113, 203, 303, 403, 703, 803, 903, 1103, 2001) that is electrically connected to the top contact comprises a ring pad (605).

7. The optical illuminator module of any of claims 1 to 5, wherein the second one of the plurality of bonding pads (204, 205, 304, 305, 404, 504, 505, 604, 605, 704, 1104, 1105, 2003, 2004) on the first surface of the submount (113, 203, 303, 403, 703, 803, 903, 1103, 2001) that is electrically connected to the top contact comprises a side bonding pad (405) located around the periphery of the two-dimensional array.

8. The optical illuminator module of any preceding claim, wherein a first section of the two-dimensional array is connected to one of the plurality of bonding pads (204, 205, 304, 305, 404, 504, 505, 604, 605, 704, 1104, 1105, 2003, 2004) on the first surface of the submount (113, 203, 303, 403, 703, 803, 903, 1103, 2001), and a second section of the two-dimensional array is connected to another of the plurality of bonding pads (204, 205, 304, 305, 404, 504, 505, 604, 605, 704, 1104, 1105, 2003, 2004) on the first surface of the submount (113, 203, 303, 403, 703, 803, 903, 1103, 2001).

9. The optical illuminator module of claim 8, wherein the first and second sections of the two-dimensional array are operated using different drive circuits.

10. The optical illuminator module of claim 9, wherein the drive circuits are programmable.

11. The optical illuminator module of any preceding claim, further comprising an optical component positioned in front of the optical output beam generated by the plurality of VCSELs.

12. The optical illuminator module of claim 11, wherein the optical component (813, 913) comprises at least one of a transparent window, a beam shaping element (814, 914), and an array of beam shaping elements (814, 914).

13. The optical illuminator module of any preceding claim, further comprising:
a) a printed circuit board (1010, 1220, 2021, 2701) comprising a plurality of high-speed transmission lines (1023, 1223) positioned on a same side of the printed circuit board (1010, 1220, 2021, 2701), wherein the submount (113, 203, 303, 403, 703, 803, 903, 1103, 2001) is electrically bonded to the plurality of high-speed transmission lines (1023, 1223); and
b) an electronic module (727, 927, 1027, 1227, 2721) comprising a current driver circuit electrically connected to the plurality of high-speed transmission lines that drives the two-dimensional array.

14. The optical illuminator module of claim 13, wherein the current drive circuit applies fast rise-time high-drive-current pulses to the two-dimensional array, thereby generating high-energy short optical pulses.

15. The optical illuminator module of any preceding claim, wherein the optical illuminator module is configured to perform at least one of motion recognition, gesture recognition, and three-dimensional sensing.

## Patentansprüche

1. Optisches Illuminatormodul, umfassend:
a) eine Vielzahl von Oberflächenemittern (VCSELs) (202, 302), die eine zweidimensionale Anordnung (111, 209, 309, 409, 509, 609, 709) bilden, die auf einem gemeinsamen Substrat (97, 101, 112, 201, 301, 701, 1301, 1401, 5101, 1601, 1701) mit einer unteren Oberfläche, die einen unteren Kontakt umfasst, der einen ersten Anschluss der zweidimensionalen Anordnung bildet, und einer oberen Oberfläche, die einen oberen Kontakt umfasst, der einen zweiten Anschluss der zweidimensionalen Anordnung bildet, aufgebaut ist, wobei die Vielzahl von VCSELs einen optischen Ausgangsstrahl (114, 308) erzeugen, der sich von der oberen Oberfläche des gemeinsamen Substrats (97, 101, 112, 201, 301, 701, 1301, 1401, 5101, 1601, 1701) ausbreitet; und
b) einen Unterträger (113, 203, 303, 403, 703, 803, 903, 1103, 2001) mit einer ersten Oberfläche, die eine Vielzahl von elektrisch voneinander isolierten Bondpads (204, 205, 304, 305, 404, 504, 505, 604, 605, 704, 1104, 1105, 2003, 2004) umfasst, und einer zweiten Oberfläche, die der ersten Oberfläche gegenüberliegt, wobei die zweite Oberfläche eine Vielzahl von elektrisch voneinander isolierten Bondpads (214, 215, 314, 315, 415, 418, 514, 515, 518, 614, 630, 1115, 2003, 2004) umfasst, wobei ein erstes entsprechendes der Vielzahl von Bondpads (204, 205, 304, 305, 404, 504, 505, 604, 605, 704, 1104, 1105, 2003, 2004) auf der ersten Oberfläche elektrisch mit einem ersten entsprechenden der Vielzahl von Bondpads (214, 215, 314, 315, 415, 418, 514, 515, 518, 614, 630, 1115, 2003, 2004) auf der zweiten Oberfläche mit einer ersten Vielzahl von Durchgangslöchern (311, 411, 511, 611, 1111, 2005) verbunden ist;
wobei der untere Kontakt des gemeinsamen Substrats (97, 101, 112, 201, 301, 701, 1301, 1401, 5101, 1601, 1701) elektrisch mit dem ersten entsprechenden der Vielzahl von Bondpads (204, 205, 304, 305, 404, 504, 505, 604, 605, 704, 1104, 1105, 2003, 2004) auf der ersten Oberfläche des Unterträgers (113, 203, 303, 403, 703, 803, 903, 1103, 2001) verbunden ist, so dass die zweidimensionale Anordnung in thermischem Kontakt mit dem Unterträger (113, 203, 303, 403, 703, 803, 903, 1103, 2001) ist, und
der obere Kontakt des gemeinsamen Substrats (97, 101, 112, 201, 301, 701, 1301, 1401, 5101, 1601, 1701) elektrisch mit einem zweiten entsprechenden der Vielzahl von Bondpads (204, 205, 304, 305, 404, 504, 505, 604, 605, 704, 1104, 1105, 2003, 2004) auf der ersten Oberfläche des Unterträgers verbunden ist,
**dadurch gekennzeichnet, dass** das zweite entsprechende der Vielzahl von Bondpads auf der ersten Oberfläche elektrisch mit einem zweiten der Vielzahl von Bondpads (214, 215, 314, 315, 415, 418, 514, 515, 518, 614, 630, 1115, 2003, 2004) auf der zweiten Oberfläche mit einer zweiten Vielzahl von Durchgangslöchern (311, 411, 511, 611, 1111, 2005) verbunden ist.

2. Optisches Illuminatormodul nach Anspruch 1, wobei die erste und zweite Vielzahl von Durchgangslöchern (311, 411, 511, 611, 1111, 2005) mit einem elektrisch und thermisch leitfähigen Material gefüllt sind.

3. Optisches Illuminatormodul nach Anspruch 2, wobei das elektrisch und thermisch leitfähige Material zumindest eines von Kupfer, Silber und Gold umfasst.

4. Optisches Illuminatormodul nach Anspruch 1, 2 oder 3, wobei der obere Kontakt elektrisch mit dem zweiten der Vielzahl von Bondpads (204, 205, 304, 305, 404, 504, 505, 604, 605, 704, 1104, 1105, 2003, 2004) auf der ersten Oberfläche des Unterträgers (113, 203, 303, 403, 703, 803, 903, 1103, 2001) mit einer Vielzahl von Drahtverbindungen (206, 210, 306, 406, 410, 506, 510, 606, 619, 706, 806, 906, 1106) verbunden ist.

5. Optisches Illuminatormodul nach Anspruch 1, 2 oder 3, wobei der obere Kontakt elektrisch mit dem zweiten der Vielzahl von Bondpads (204, 205, 304, 305, 404, 504, 505, 604, 605, 704, 1104, 1105, 2003, 2004) auf der ersten Oberfläche des Unterträgers (113, 203, 303, 403, 703, 803, 903, 1103, 2001) mit einem breiten Bondbändchen (206, 210, 306, 806, 1106) verbunden ist.

6. Optisches Illuminatormodul nach einem vorstehenden Anspruch, wobei das zweite der Vielzahl von Bondpads (204, 205, 304, 305, 404, 504, 505, 604, 605, 704, 1104, 1105, 2003, 2004) auf der ersten Oberfläche des Unterträgers (113, 203, 303, 403, 703, 803, 903, 1103, 2001), das elektrisch mit dem oberen Kontakt verbunden ist, ein Ringpad (605) umfasst.

7. Optisches Illuminatormodul nach einem der Ansprüche 1 bis 5, wobei das zweite der Vielzahl von Bondpads (204, 205, 304, 305, 404, 504, 505, 604, 605, 704, 1104, 1105, 2003, 2004) auf der ersten Oberfläche des Unterträgers (113, 203, 303, 403, 703, 803, 903, 1103, 2001), das elektrisch mit dem oberen Kontakt verbunden ist, ein Seiten-Bondpad (405) umfasst, das um den Umfang der zweidimensionalen Anordnung herum angeordnet ist.

8. Optisches Illuminatormodul nach einem vorstehenden Anspruch, wobei ein erster Abschnitt der zweidimensionalen Anordnung mit einem der Vielzahl von Bondpads (204, 205, 304, 305, 404, 504, 505, 604, 605, 704, 1104, 1105, 2003, 2005) auf der ersten Oberfläche des Unterträgers (113, 203, 303, 403, 703, 803, 903, 1103, 2001) verbunden ist, und ein zweiter Abschnitt der zweidimensionalen Anordnung mit einem anderen der Vielzahl von Bondpads (204, 205, 304, 305, 404, 504, 505, 604, 605, 704, 1104, 1105, 2003, 2004) auf der ersten Oberfläche des Unterträgers (113, 203, 303, 403, 703, 803, 903, 1103, 2001) verbunden ist.

9. Optisches Illuminatormodul nach Anspruch 8, wobei die ersten und zweiten Abschnitte der zweidimensionalen Anordnung unter Verwendung verschiedener Ansteuerschaltungen betrieben werden.

10. Optisches Illuminatormodul nach Anspruch 9, wobei die Ansteuerschaltungen programmierbar sind.

11. Optisches Illuminatormodul nach einem vorstehenden Anspruch, weiter umfassend eine optische Komponente, die vor dem optischen Ausgangsstrahl positioniert ist, der durch die Vielzahl von VCSELs erzeugt wird.

12. Optisches Illuminatormodul nach Anspruch 11, wobei die optische Komponente (813, 913) mindestens eines von einem transparenten Fenster, einem Strahlformungselement (814, 914) und einer Anordnung von Strahlformungselementen (814, 914) umfasst.

13. Optisches Illuminatormodul nach einem vorstehenden Anspruch, weiter umfassend:
a) eine Leiterplatte (1010, 1220, 2021, 2701), die eine Vielzahl von Hochgeschwindigkeits-Übertragungsleitungen (1023, 1223) umfasst, die auf der gleichen Seite der Leiterplatte (1010, 1220, 2021, 2701) positioniert sind, wobei der Unterträger (113, 203, 303, 403, 703, 803, 903, 1103, 2001) elektrisch mit der Vielzahl von Hochgeschwindigkeits-Übertragungsleitungen (1023, 1223) verbunden ist; und
b) ein elektronisches Modul (727, 927, 1027, 1227, 2721), das eine Stromtreiberschaltung umfasst, die elektrisch mit der Vielzahl von Hochgeschwindigkeits-Übertragungsleitungen verbunden ist, welche die zweidimensionale Anordnung antreibt.

14. Optisches Illuminatormodul nach Anspruch 13, wobei die Stromtreiberschaltung Hochantriebsstrompulse mit schneller Anstiegszeit an die zweidimensionale Anordnung anlegt und dadurch hochenergetische, kurze optische Impulse erzeugt.

15. Optisches Illuminatormodul nach einem vorstehenden Anspruch, wobei das optische Illuminatormodul so konfiguriert ist, dass es mindestens eines von einer Bewegungserkennung, einer Gestenerkennung und einer dreidimensionalen Abtastung ausführt.

## Revendications

1. Module d'éclairage optique comprenant :
a) une pluralité de lasers à cavité verticale émettant en surface (VCSEL) (202, 302) formant un réseau bidimensionnel (111, 209, 309, 409, 509, 609, 709) construit sur un substrat commun (97, 101, 112, 201, 301, 701, 1301, 1401, 5101, 1601, 1701) ayant une surface inférieure comprenant un contact inférieur formant une première borne du réseau bidimensionnel et une surface supérieure comprenant un contact supérieur formant une seconde borne du réseau bidimensionnel, la pluralité de VCSEL générant un faisceau de sortie optique (114, 308) qui se propage depuis la surface supérieure du substrat commun (97, 101, 112, 201, 301, 701, 1301, 1401, 5101, 1601, 1701) ; et
b) un sous-montage (113, 203, 303, 403, 703, 803, 903, 1103, 2001) comportant une première surface comprenant une pluralité de plots de connexion (204, 205, 304, 305, 404, 504, 505, 604, 605, 704, 1104, 1105, 2003, 2004) isolés électriquement les uns des autres et une seconde surface qui est opposée à la première surface, la seconde surface comprenant une pluralité de plots de connexion (214, 215, 314, 315, 415, 418, 514, 515, 518, 614, 630, 1115, 2003, 2004) isolés électriquement les uns des autres, dans lequel un premier plot respectif de la pluralité de plots de connexion (204, 205, 304, 305, 404, 504, 505, 604, 605, 704, 1104, 1105, 2003, 2004) sur la première surface est connecté électriquement à un premier plot respectif de la pluralité de plots de connexion (214, 215, 314, 315, 415, 418, 514, 515, 518, 614, 630, 1115, 2003, 2004) sur la seconde surface avec une première pluralité de trous traversants (311, 411, 511, 611, 1111, 2005) ;
dans lequel le contact inférieur du substrat commun (97, 101, 112, 201, 301, 701, 1301, 1401, 5101, 1601, 1701) est connecté électriquement au premier plot respectif de la pluralité de plots de connexion (204, 205, 304, 305, 404, 504, 505, 604, 605, 704, 1104, 1105, 2003, 2004) sur la première surface du sous-montage (113, 203, 303, 403, 703, 803, 903, 1103, 2001) de sorte que le réseau bidimensionnel soit en contact thermique avec le sous-montage (113, 203, 303, 403, 703, 803, 903, 1103, 2001), et
le contact supérieur du substrat commun (97, 101, 112, 201, 301, 701, 1301, 1401, 5101, 1601, 1701) est connecté électriquement à un second plot respectif de la pluralité de plots de connexion (204, 205, 304, 305, 404, 504, 505, 604, 605, 704, 1104, 1105, 2003, 2004) sur la première surface du sous-montage,
**caractérisé en ce que** le second plot respectif de la pluralité de plots de connexion sur la première surface est connecté électriquement à un second plot de la pluralité de plots de connexion (214, 215, 314, 315, 415, 418, 514, 515, 518, 614, 630, 1115, 2003, 2004) sur la seconde surface avec une seconde pluralité de trous traversants (311, 411, 511, 611, 1111, 2005).

2. Module d'éclairage optique selon la revendication 1, dans lequel les première et seconde pluralités de trous traversants (311, 411, 511, 611, 1111, 2005) sont remplis d'un matériau électriquement et thermiquement conducteur.

3. Module d'éclairage optique selon la revendication 2, dans lequel le matériau électriquement et thermiquement conducteur comprend au moins un élément parmi le cuivre, l'argent et l'or.

4. Module d'éclairage optique selon la revendication 1, 2 ou 3, dans lequel le contact supérieur est connecté électriquement au second plot de la pluralité de plots de connexion (204, 205, 304, 305, 404, 504, 505, 604, 605, 704, 1104, 1105, 2003, 2004) sur la première surface du sous-montage (113, 203, 303, 403, 703, 803, 903, 1103, 2001) avec une pluralité de connexions filaires (206, 210, 306, 406, 410, 506, 510, 606, 619, 706, 806, 906, 1106).

5. Module d'éclairage optique selon la revendication 1, 2 ou 3, dans lequel le contact supérieur est connecté électriquement au second plot de la pluralité de plots de connexion (204, 205, 304, 305, 404, 504, 505, 604, 605, 704, 1104, 1105, 2003, 2004) sur la première surface du sous-montage (113, 203, 303, 403, 703, 803, 903, 1103, 2001) avec un large ruban de connexion (206, 210, 306, 806, 1106).

6. Module d'éclairage optique selon l'une quelconque des revendications précédentes, dans lequel le second plot de la pluralité de plots de connexion (204, 205, 304, 305, 404, 504, 505, 604, 605, 704, 1104, 1105, 2003, 2004) sur la première surface du sous-montage (113, 203, 303, 403, 703, 803, 903, 1103, 2001) qui est connectée électriquement au contact supérieur comprend un plot annulaire (605).

7. Module d'éclairage optique selon l'une quelconque des revendications 1 à 5, dans lequel le second plot de la pluralité de plots de connexion (204, 205, 304, 305, 404, 504, 505, 604, 605, 704, 1104, 1105, 2003, 2004) sur la première surface du sous-montage (113, 203, 303, 403, 703, 803, 903, 1103, 2001) qui est connecté électriquement au contact supérieur comprend un plot de connexion latéral (405) situé autour de la périphérie du réseau bidimensionnel.

8. Module d'éclairage optique selon l'une quelconque des revendications précédentes, dans lequel une première section du réseau bidimensionnel est connectée à l'un de la pluralité de plots de connexion (204, 205, 304, 305, 404, 504, 505, 604, 605, 704, 1104, 1105, 2003, 2004) sur la première surface du sous-montage (113, 203, 303, 403, 703, 803, 903, 1103, 2001), et une seconde section du réseau bidimensionnel est connectée à un autre plot de la pluralité de plots de connexion (204, 205, 304, 305, 404, 504, 505, 604, 605, 704, 1104, 1105, 2003, 2004) sur la première surface du sous-montage (113, 203, 303, 403, 703, 803, 903, 1103, 2001).

9. Module d'éclairage optique selon la revendication 8, dans lequel les première et seconde sections du réseau bidimensionnel sont actionnées avec des circuits de commande différents.

10. Module d'éclairage optique selon la revendication 9, dans lequel les circuits de commande sont programmables.

11. Module d'éclairage optique selon l'une quelconque des revendications précédentes, comprenant en outre un composant optique positionné devant le faisceau de sortie optique généré par la pluralité de VCSEL.

12. Module d'éclairage optique selon la revendication 11, dans lequel le composant optique (813, 913) comprend au moins l'un parmi une fenêtre transparente, un élément de mise en forme de faisceau (814, 914), et un réseau d'éléments de mise en forme de faisceau (814, 914).

13. Module d'éclairage optique selon l'une quelconque des revendications précédentes, comprenant en outre :
a) une carte de circuit imprimé (1010, 1220, 2021, 2701) comprenant une pluralité de lignes de transmission à grande vitesse (1023, 1223) positionnées sur un même côté de la carte de circuit imprimé (1010, 1220, 2021, 2701), dans lequel le sous-montage (113, 203, 303, 403, 703, 803, 903, 1103, 2001) est lié électriquement à la pluralité de lignes de transmission à grande vitesse (1023, 1223) ; et
b) un module électronique (727, 927, 1027, 1227, 2721) comprenant un circuit de commande de courant connecté électriquement à la pluralité de lignes de transmission à grande vitesse qui commande le réseau bidimensionnel.

14. Module d'éclairage optique selon la revendication 13, dans lequel le circuit de commande de courant applique des impulsions de courant de commande élevé à temps de montée rapide au réseau bidimensionnel, générant ainsi des impulsions optiques courtes à haute énergie.

15. Module d'éclairage optique selon l'une quelconque des revendications précédentes, dans lequel le module d'éclairage optique est configuré pour effectuer au moins l'une d'une reconnaissance de mouvement, d'une reconnaissance de geste, et d'une détection tridimensionnelle.
